(19) Europäisches Patentamt
European Patent Office
Office européen des brevets

(11) **EP 4 325 227 B1**

(12) **EUROPÄISCHE PATENTSCHRIFT**

(45) Veröffentlichungstag und Bekanntmachung des Hinweises auf die Patenterteilung:
**01.10.2025   Patentblatt 2025/40**

(21) Anmeldenummer: **22190456.8**

(22) Anmeldetag: **16.08.2022**

(51) Internationale Patentklassifikation (IPC):
**G01R 1/067** (2006.01)

(52) Gemeinsame Patentklassifikation (CPC):
**G01R 1/06761; B32B 15/01; C22C 5/04; C22C 9/00**

(54) **BANDFÖRMIGER VERBUNDWERKSTOFF FÜR PRÜFNADELN**

TAPE-LIKE COMPOSITE MATERIAL FOR TEST NEEDLES

MATIÈRE COMPOSITE EN FORME DE RUBAN POUR AIGUILLES DE CONTRÔLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**21.02.2024   Patentblatt 2024/08**

(73) Patentinhaber: **Heraeus Precious Metals GmbH & Co. KG**
**63450 Hanau (DE)**

(72) Erfinder:
• **FECHER, Jonas**
**63450 Hanau (DE)**
• **SCHUMANN, Marc**
**63450 Hanau (DE)**

(74) Vertreter: **Heraeus IP**
**Heraeus Business Solutions GmbH**
**Intellectual Property**
**Heraeusstraße 12-14**
**63450 Hanau (DE)**

(56) Entgegenhaltungen:
EP-A1- 2 139 012     EP-A1- 2 159 581
EP-A1- 3 878 986     DE-T2- 69 635 227
JP-A- 2006 064 511   US-A1- 2019 064 215

**Beschreibung**

Die Erfindung betrifft einen bandförmigen, sandwichartig geschichteten Verbundwerkstoff, aus dem Prüfnadeln zur elektronischen Prüfung von Halbleiterelementen gestanzt oder geschnitten werden können sowie eine Prüfnadel, ein Bondband und ein Prüfnadelarray, das aus oder mit einem solchen bandförmigen, sandwichartig geschichteten Verbundwerkstoff hergestellt ist.

Die Erfindung betrifft auch ein Verfahren zur Herstellung eines solchen bandförmigen, sandwichartig geschichteten Verbundwerkstoffs aus zwei unterschiedlichen Materialien aus Bändern.

Aus dem Verbundwerkstoff können neben Prüfnadeln auch Bondbänder beziehungsweise Bonddrähte gefertigt werden, die von den gleichen physikalischen Eigenschaften profitieren, wie Prüfnadeln. Bondbänder sind bandförmige Bonddrähte.

Während der Chipproduktion werden Wafer direkt nach der Prozessierung mit Prüfnadeln kontaktiert, um die Funktionsfähigkeit der von integrierten Schaltungen (IC) in ungesägtem Zustand zu testen. Ein Array von Prüfnadeln testet dabei nach der Strukturierung der einzelnen Chips den Halbleiterwafer auf Funktionalität. Die Prüfnadeln sind in einer Testkarte (probe card) fixiert, die auf das Design des Wafers abgestimmt ist. Beim Prüfprozess wird der Wafer auf die Prüfnadeln gepresst und eine Kontaktierung zwischen Prüfnadeln und den Pads der ICs hergestellt. Daraufhin werden verschiedene Parameter getestet, wie zum Beispiel die Kontaktierung, elektrische Kennwerte bei hoher Stromdichte und das elektrische Verhalten bei Temperaturwechseln.

Prüfnadeln werden also bei der Herstellung von Leistungselektronik, der Kontaktierung von Chips und anderen elektrischen Schaltungen zur Prüfung der Qualität von elektrischen Kontaktierungen eingesetzt (siehe hierzu beispielsweise die US 2014/0266278 A1 und die US 2010/0194415 A1).

Anwendungen wie Prüfnadeln oder Bondbänder in der Leistungselektronik erfordern neben einer hohen elektrischen Leitfähigkeit auch eine hohe mechanische Festigkeit und Härte. Zudem ist die Temperaturbeständigkeit beziehungsweise Warmfestigkeit von entscheidender Bedeutung.

Die Schlüsselparamater einer guten Prüfnadel sind eine hohe elektrische Leitfähigkeit, da beim Prüfer der ICs für Leistungselektronik hohe elektrische Ströme übertragen werden müssen, sowie eine hohe Härte, um die Wartungsintervalle gering zu halten. Zudem profitieren Prüfnadeln und Bondbänder von einem geringem E-Modul ($m_E$) und einer hohen Streckgrenze ($Rp_{0,2}$), welche gute Federeigenschaften hervorrufen. Eine hohe thermische Leitfähigkeit bewirkt eine gute Abfuhr der Wärmeenergie und damit eine möglichst geringe zusätzliche thermische Erhöhung des elektrischen Widerstands. Geeignete Härte, E-Modul und Streckgrenze werden benötigt, um zum einen die Wartungsintervalle gering zu halten und zum anderen um gute Federeigenschaften der Prüfnadel zu realisieren.

Die elektrische Leitfähigkeit von reinem Kuper (100% IACS = 58,1 * $10^6$ S/m) dient als Referenz zur Bestimmung der elektrischen Leitfähigkeit. Reines Kupfer (Cu) und reines Silber (Ag) können zu diesen Zwecken jedoch nicht eingesetzt werden, da sie deutlich zu duktil sind und sich die Prüfnadel beim Einsatz verformen würde.

Anwendungen wie Prüfnadeln ("Probe Needles") oder Bondbänder in der Leistungselektronik erfordern neben einer hohen elektrischen Leitfähigkeit auch eine hohe mechanische Festigkeit und Härte. Dabei ist auch die Temperaturbeständigkeit beziehungsweise die Warmfestigkeit von entscheidender Bedeutung.

Als Materialien für Prüfnadeln werden derzeit ausscheidungsgehärtete Kupfer-Legierungen, Rhodium-Legierungen (Rh-Legierungen) oder Palladium-Legierungen (Pd-Legierungen) verwendet, welche durch Kokillenguss, Lösungsglühen, Ausscheidungswärmebehandlung und Walzen zu dünnen Bändern mit einer Dicke von weniger als 55 $\mu$m verarbeitet werden.

Für die Anwendung auf Goldpads sind Palladium-Legierungen bekannt, wie beispielsweise Paliney® H3C der Firma Deringer Ney oder NewTec® der Firma Advanced Probing. Typische Materialien für Prüfnadeln sind ausscheidungsgehärtete Palladium-Silber-Legierungen, die 10 Gew% Gold und 10 Gew% Platin enthalten können und beispielsweise unter den Produktnamen Paliney® 7, Hera 6321 und Hera 648 vertrieben werden. Die US 2014/377 129 A1 und die US 5 833 774 A offenbaren gehärtete Ag-Pd-Cu-Legierungen für elektrische Anwendungen. Diese Legierungen weisen eine hohe Härte von 400-500 HV auf. Die elektrische Leitfähigkeit ist mit 9-12 % IACS aber eher gering. Die hohe elektrische Leitfähigkeit ist ein entscheidender Faktor bei Prüfnadeln.

Für das Testen auf Aluminiumpads sind Prüfnadeln aus den Materialien Wolfram, Wolframcarbid, Palladium-Kupfer-Silber-Legierungen und Wolfram-Rhenium weit verbreitet. Diese sind besonders hart, wobei Aluminiumpads robuster als Goldpads sind und einer Prüfung mit harten Nadeln besser standhalten können als Goldpads. Diese Prüfnadeln haben auch keine sehr hohe elektrische Leitfähigkeit. Legierungen mit höherer elektrischer Leitfähigkeit wie CuAg7 sind weniger hart (ca. 320 HV1) und weniger warmfest als Palladium-Silber-Legierungen oder Palladium-Kupfer-Silber-Legierungen.

Weiterhin existieren PtNi30-Legierungen für Prüfnadeln im Markt. Aus der US 2010/0239453 A1 und der EP 2 248 920 A1 sind niedrig dotierte Iridium-Legierungen zur Herstellung von Prüfnadeln bekannt.

Die US 2006/0197542 A1 offenbart eine Platin-Basislegierung zum Herstellen von Prüfnadeln. Die Legierungen weisen eine hohe Härte zwischen 300 HV und 500 HV auf, um einen guten Kontakt durch eine auf den Goldpads angeordnete Lackschicht herstellen zu können.

Bereits aus der US 1 913 423 A und der GB 354 216 A sind grundsätzlich geeignete Palladium-Kupfer-Silber-Legierungen bekannt. Palladium-Kupfer-Silber-Legierung können eine Struktur mit einem Übergitter ausbilden, die zu einer Verbesserung der elektrischen Leitfähigkeit und der mechanischen Stabilität der Legierung führt. Die Atome in dem Gitter sind dann nicht mehr statistisch zufällig verteilt, sondern sie ordnen sich in periodischen Strukturen, dem Übergitter an. Hierdurch sind Härten von mehr als 350 HV1 (Vickers Härteprüfung nach DIN EN ISO 6507-1:2018 bis -4:2018 mit einer Prüfkraft von 9,81 N (1 Kilopond)), elektrische Leitfähigkeiten von mehr als 19,5% IACS und Bruchfestigkeiten bis zu 1500 MPa möglich. Während Palladium-Legierungen, wie die aus der EP 3 960 890 A1 bekannte Palladium-Kupfer-Silber-Ruthenium/Rhodium-Legierung, und die aus dem Stand der Technik bekannten Platin-Basislegierungen über sehr gute mechanische Eigenschaften auch bei hohen Temperaturen verfügen, ist die elektrische Leitfähigkeit und die Wärmeleitfähigkeit im Vergleich zu Kupfer und Kupfer-Legierungen weniger gut.

Als Materialien für Folien zur Herstellung von Prüfnadeln werden aber auch PtNi-Legierungen (Platin-Nickel-Legierungen) oder Rhodium (Rh) verwendet. Bei solchen Metallen oder Legierungen, die einen möglichst guten Kompromiss zwischen elektrischer Leitfähigkeit, thermischer Leitfähigkeit, Zugfestigkeit sowie Härte darstellen, beträgt die maximal mögliche elektrische Leitfähigkeit 5% bis 30% IACS und ist damit im Vergleich zu Kupfer eher gering.

Die US 10 385 424 B2 offenbart eine Palladium-Kupfer-Silber-Legierung zusätzlich enthaltend bis zu 5 Gew% Rhenium. Diese Palladium-Kupfer-Silber-Legierung wird unter dem Produktnamen Paliney® 25 vertrieben. Hiermit kann die elektrische Leitfähigkeit deutlich erhöht werden und erreicht Werte von mehr als 19,5% IACS. Nachteilig ist hieran jedoch, dass Rhenium einen sehr hohen Schmelzpunkt von 3180 °C hat und daher aufwendig mit den anderen Metallen legiert werden muss.

Die WO 2016/009293 A1 schlägt eine Prüfnadel vor, wobei an der Vorderseite der Prüfnadel eine Spitze angeordnet ist, die aus einem mechanisch harten ersten Material besteht und der Rest der Prüfnadel aus einem zweiten Material mit einer hohen elektrischen Leitfähigkeit besteht. Ähnliche Prüfnadeln sind auch aus der US 2013/0099813 A1, der US 2016/0252547 A1, der EP 2 060 921 A1 und der US 2012/0286816 A1 bekannt. Mit der US 2019/0101569 A1 wird ein Manteldraht mit einer solchen Spitze vorgeschlagen, wobei die Spitze nur an der Drahtseele des Manteldrahts befestigt wird. Der Manteldraht soll dabei eine Drahtseele mit einer einzelnen Beschichtung aufweisen. Nachteilig ist hieran, dass die Prüfnadel über ihre Länge keine homogenen physikalischen Eigenschaften mehr hat und dass die elektrische und thermische Leitfähigkeit aber auch die Zugfestigkeit sehr stark von der Verbindung zwischen den beiden Materialien abhängt. Zudem lässt sich eine niedrige elektrische Leitfähigkeit in einem Bereich nicht einfach durch eine hohe elektrische Leitfähigkeit in einem anderen Bereich ausgleichen, da der Strom wie bei Reihenschaltungen von elektrischen Widerständen beide Bereiche passieren muss.

Als Verbunddrähte zur Herstellung von Prüfnadeln oder Bonddrähten können beispielsweise rundumbeschichtete Drähte eingesetzt werden, die als sogenannte Manteldrähte oder Double-Drähte durch endlos Walzprozesse oder mit Hilfe von galvanischen Beschichtungen hergestellt werden können. Beispielsweise können diese im Inneren ein Unedel-Metall, beispielsweise aus einer Cu-Legierung wie CuBe2 aufweisen, ummantelt mit einer Edelmetall- Legierung (beispielsweise Hera238), um für kontakttechnische Anwendungen bei gleitenden Kontakten in Schleifringübertragern oder auch Schaltkontakten in Mikroschaltern eingesetzt werden zu können, so wie dies in der DE 10 2019 130 522 A1 beschrieben ist. Ein Manteldraht zum Herstellen einer Prüfnadel ist aus der DE 696 35 227 T2 bekannt. Dieser Manteldraht enthält einen weichen Kern aus Gold, Aluminium, Kupfer oder deren Legierungen und einen harten Mantel aus Nickel oder einer Nickellegierung. Aus der EP 2 139 012 A1 ist ein mit Silber beschichtetes Material als Schleifkontakt bekannt, das eine elektrisch leitfähige Basis aus Kupfer, eine Unterschicht aus Nickel oder einer Nickel-Legierung, eine Zwischenschicht aus Palladium, Palladium-Legierung oder Silber-Zinn-Legierung und eine äußere (obere) Oberflächenschicht aus Silber oder einer Silber-Legierung besteht. Die US 2019/0064215 A1 offenbart eine MEMS-Sonde zur Messung einer elektrischen Kontaktierung, die vorgebogen ist und aus einer Mehrzahl plattierter Schichten besteht. Die Schichten können aus elektrisch leitfähigen Metallen oder aus einem Material mit einem Elastizitätskoeffizient größer als dem des elektrisch leitfähigen Metalls bestehen, wobei eine große Vielzahl an unterschiedlichen metallischen und keramischen Materialien genannt wird.

Zur Verbesserung der elektrischen Leitfähigkeit der Prüfnadeln wird derzeit auch Rein-Kupfer galvanisch auf Palladium-Legierungen abgeschieden. Eine galvanische Beschichtung von Rhodium-Basislegierungen zur Herstellung eines Manteldrahts als Prüfnadel ist aus der EP 3 862 759 B1 bekannt. Weitere beschichtete Prüfnadeln sind aus der WO 2016/107729 A1, der US 2017/0307657 A1 und der US 2014/0176172 A1 bekannt.

Nachteilig ist hieran, dass Rein-Kupfer nur eine geringe Härte, Warmfestigkeit und schlechte Federeigenschaften hat, wodurch die mechanischen Eigenschaften des so erzeugten Verbundwerkstoffs aus Palladium-Legierung und Kupfer negativ beeinflusst werden.

Es wäre also wünschenswert, die galvanische beschichteten Palladium-Legierungen dahingehend zu verbessern, dass eine Verbesserung der elektrischen Leitfähigkeit ohne eine gleichzeitige Verschlechterung oder mit einer geringeren Verschlechterung der mechanischen Eigenschaften des Verbundwerkstoffs und der daraus hergestellten Prüfnadeln oder Bondbänder erzielt werden kann.

Die Aufgabe der Erfindung besteht also darin, die Nachteile des Stands der Technik zu überwinden. Insbesondere soll ein Verbundwerkstoff zur Herstellung von Prüfnadeln zur elektronischen Prüfung von Halbleiterelementen daraus (und zwar durch Stanzen oder Schneiden) sowie ein Verfahren zur Herstellung eines solchen Verbundwerkstoffs gefunden werden, bei dem der Verbundwerkstoff eine im Vergleich zu Palladium-Legierungen verbesserte elektrische Leitfähigkeit aufweist, ohne dass dabei die mechanischen Eigenschaften, insbesondere die Zugfestigkeit und die Warmzugfestigkeit und bevorzugt auch die Härte sich derart verschlechtert, wie das bei den galvanisch mit Rein-Kupfer beschichteten Palladium-Legierungen der Fall ist. Der Verbundwerkstoff und das Verfahren sollen einfach und kostengünstig zu realisieren sein und für die Massenproduktion tauglich sein. Aus dem Verbundwerkstoff sollen auf möglichst einfache und kostengünstige Weise Prüfnadeln und Bondbänder herstellbar sein, wobei die Spitze der Prüfnadel bevorzugt aus einer harten Palladium-Legierung oder Platin-Legierung bestehen soll. Ferner soll der Verbundwerkstoff eine möglichst mechanisch stabile Verbindung zwischen den Materialien des Verbundwerkstoffs aufweisen.

Die Aufgaben der Erfindung werden gelöst durch einen Verbundwerkstoff nach Anspruch 1, durch eine Prüfnadel oder ein Bondband nach Anspruch 9, durch ein Prüfnadelarray nach Anspruch 11, durch die Verwendung eines Verbunds, einer Prüfnadel oder eines Prüfnadelarrays nach Anspruch 12 sowie durch ein Verfahren nach Anspruch 13. Bevorzugte Ausführungen sind in den Unteransprüchen 2 bis 8, 10, 14 und 15 gezeigt.

Die Aufgaben der Erfindung werden gelöst durch einen Verbundwerkstoff zur Herstellung von Prüfnadeln zur elektronischen Prüfung von Halbleiterelementen, wobei der Verbundwerkstoff bandförmig ist und von zwei zueinander parallelen Hauptflächen begrenzt ist, wobei der Verbundwerkstoff senkrecht zu den parallelen Hauptflächen geschichtet ist und eine Sandwichbauweise mit einer inneren Kernschicht und zwei äußeren Deckschichten aufweist, wobei die innere Kernschicht zwischen den zwei äußeren Deckschichten angeordnet ist und die innere Kernschicht auf zwei gegenüberliegenden Seiten mit den zwei äußeren Deckschichten fest verbunden ist, wobei die zwei äußeren Deckschichten die parallelen Hauptflächen bilden, wobei die innere Kernschicht aus einer Palladium-Legierung mit zumindest 30 Gew% Palladium oder aus einer Platin-Legierung mit zumindest 30 Gew% Platin besteht und wobei die zwei äußeren Deckschichten aus einer ausscheidungsgehärteten und/oder dispersionsgehärteten Kupfer-Legierung mit zumindest 90 Gew% Kupfer oder aus einer ausscheidungsgehärteten und/oder dispersionsgehärteten Silber-Legierung mit zumindest 70 Gew% Silber oder aus einer ausscheidungsgehärteten und/oder dispersionsgehärteten Kupfer-Legierung mit zumindest 90 Gew% Kupfer und aus einer ausscheidungsgehärteten und/oder dispersionsgehärteten Silber-Legierung mit zumindest 70 Gew% Silber bestehen.

Ausscheidungsgehärtete Kupfer-Legierungen und Silber-Legierungen bewirken eine hohe Härte und Zugfestigkeit.

Dispersionsgehärtete Kupfer-Legierungen und Silber-Legierungen bewirken eine hohe Härte und Zugfestigkeit auch bei hohen Temperaturen.

Die ausscheidungsgehärtete und/oder dispersionsgehärtete Kupfer-Legierung und die ausscheidungsgehärtete und/oder dispersionsgehärtete Silber-Legierung können sowohl ausscheidungsgehärtet als auch dispersionsgehärtet sein.

Bei einer Ausscheidungshärtung einer Legierung entstehen durch eine Temperaturbehandlung Ausscheidungen in der Legierung. Bei einer Dispersionshärtung einer Legierung werden Dispersoide in der Legierung verteilt. Die Dispersoide können als Partikel in der Schmelze vor dem Erstarren verteilt sein. Solche Dispersoide sind häufig Oxide oder Boride, erfindungsgemäß bevorzugt Metall-Oxide.

Die parallelen Hauptflächen bilden die größte Oberfläche des bandförmigen Verbundwerkstoffs. Bevorzugt bilden die parallelen Hauptflächen zumindest 50% der Oberfläche des bandförmigen Verbundwerkstoffs, besonders bevorzugt bilden die parallelen Hauptflächen zumindest 90% der Oberfläche des bandförmigen Verbundwerkstoffs, ganz besonders bevorzugt bilden die parallelen Hauptflächen zumindest 99% der Oberfläche des bandförmigen Verbundwerkstoffs. Der bandförmige Verbundwerkstoff hat vorzugsweise in erster Näherung oder in guter Näherung die Form eines flachen Quaders.

Die zwei äußeren Deckschichten können aus unterschiedlichen Kupfer-Legierungen oder Silber-Legierungen bestehen. Es kann auch eine der zwei äußeren Deckschichten aus einer Kupfer-Legierung und die andere der zwei äußeren Deckschichten aus einer Silber-Legierung bestehen. Es wird jedoch erfindungsgemäß bevorzugt, dass die beiden äußeren Deckschichten aus der der gleichen Kupfer-Legierung oder Silber-Legierung bestehen, besonders bevorzugt aus der gleichen Kupfer-Legierung.

Die zueinander parallelen Hauptflächen müssen nicht im mathematischen Sinne vollkommen zueinander parallele oder planparallele Flächen bilden. Es reicht aus, wenn die zueinander parallelen Hauptflächen bis zu einem Winkel von maximal 5° gegeneinander geneigt sind. Bevorzugt sind die zueinander parallelen Hauptflächen mit einem Winkel von maximal 1° gegeneinander geneigt.

Ebenfalls bevorzugt sind die zueinander parallelen Hauptflächen planparallel.

Bevorzugt sind die zueinander parallelen Hauptflächen ebene Flächen. Auch hier ist mit einer ebenen Fläche keine auf atomarem Bereich ebene Fläche gemeint, sondern eine ebene Fläche, wie sie beim Walzen entsteht.

Die Prüfnadeln und Bondbänder können aus dem bandförmigen Verbundwerkstoff hergestellt werden, indem Streifen des Verbundwerkstoffs senkrecht zu den parallelen Hauptflächen oder auch diagonal zu den parallelen Hauptflächen geschnitten werden. Zudem kann ein Ende der Nadel angespitzt werden und zwar bevorzugt in der Art, dass das Material der inneren Kernschicht eine Spitze der Prüfnadel bildet. Mit dieser Spitze kann dann eine Halbleiterstruktur hinsichtlich ihrer elektrischen Leitfähigkeit geprüft werden, indem die Spitze auf die zu untersuchende Halbleiteroberfläche gedrückt wird und die elektrische Leitfähigkeit über die Prüfnadel gemessen wird.

Unter einer Verunreinigung ist vorliegend eine durch die Darstellung aller beteiligten Elemente bedingte Verunreinigung zu verstehen.

Wenn das Material als Prüfnadel einsetzbar ist, dann ist es auch für den Einsatz als Bondband beziehungsweise Bonddraht geeignet.

Bevorzugt sind die innere Kernschicht und die zwei äußeren Deckschichten metallisch. Ausscheidungsgehärtete und dispersionsgehärtete Kupfer-Legierungen und Silber-Legierungen bewirken eine hohe Härte und Zugfestigkeit des Verbundwerkstoffs auch bei hohen Temperaturen (etwa 300 °C).

Es kann bevorzugt vorgesehen sein, dass die innere Kernschicht mit den zwei äußeren Deckschichten gefügt ist, insbesondere durch walzplattieren gefügt ist.

Es kann vorgesehen sein, dass der bandförmige Verbundwerkstoff eine Stärke von maximal 300 $\mu$m hat, bevorzugt eine Stärke von maximal 100 $\mu$m hat.

Die Stärke des Verbundwerkstoffs entspricht dem Abstand der beiden Hauptebenen, die von den äußeren Flächen der zwei äußeren Deckschichten gebildet werden.

Dickere Verbundwerkstoffe sind ohne zusätzliches Walzen nicht ohne weiteres durch Schneiden oder Stanzen des Verbundwerkstoffs als Prüfnadeln einsetzbar.

Ferner kann vorgesehen sein, dass die Dicke der inneren Kernschicht zumindest gleich dick ist wie die Dicke der beiden äußeren Deckschichten, bevorzugt zumindest doppelt so dick ist wie die Dicke der beiden äußeren Deckschichten.

Auch kann vorgesehen sein, dass die Dicke der inneren Kernschicht maximal zehnmal so dick ist wie die Dicke der beiden äußeren Deckschichten, bevorzugt maximal fünfmal so dick ist wie die Dicke der beiden äußeren Deckschichten, besonders bevorzugt maximal dreimal so dick ist wie die Dicke der beiden äußeren Deckschichten.

Hierdurch wird sichergestellt, dass die physikalischen Eigenschaften des Verbunds von den Materialien der Deckschichten und der Kernschicht gemeinsam bestimmt werden.

Es kann vorgesehen sein, dass die innere Kernschicht unmittelbar mit den zwei äußeren Deckschichten verbunden ist.

Das bedeutet, dass zwischen der inneren Kernschicht und den zwei äußeren Deckschichten keine weiteren Schichten, wie zum Beispiel eine Haftschicht und/oder eine Diffusionsschutzschicht angeordnet sind.

Durch diese Maßnahme ist die Herstellung des Verbundwerkstoffs einfach und kostengünstig zu realisieren. Es hat sich gezeigt, dass bei der Herstellung des erfindungsgemäßen Verbundwerkstoffs mit einem erfindungsgemäßen Verfahren keine zusätzliche Zwischenschicht benötigt wird. Es kann beim Walzplattieren und bei einer nachfolgenden Wärmebehandlung eine Diffusionsschicht zwischen der inneren Kernschicht und den zwei äußeren Deckschichten entstehen. Diese wird nicht als eigene (weitere) Schicht im Sinne der vorliegenden Erfindung betrachtet, sondern als Verbindung im Bereich der Grenzfläche zwischen der inneren Kernschicht und den zwei äußeren Deckschichten.

Des Weiteren kann vorgesehen sein, dass der Verbundwerkstoff aus der inneren Kernschicht und den äußeren Deckschichten besteht.

Hierdurch wird klargestellt, dass der Verbundwerkstoff keine weiteren Schichten oder Teile benötigt. Dadurch ist der Verbundwerkstoff kostengünstig in der Herstellung.

Alternativ könnten beispielsweise die zwei äußeren Deckschichten an den Hauptflächen beschichtet sein oder es könnte an einer Kante des Verbundwerkstoffs ein Material zur elektrischen Kontaktierung der Prüfnadeln aufgetragen sein.

Auch kann vorgesehen sein, dass die zwei äußeren Deckschichten aus einer ausscheidungsgehärteten und/oder dispersionsgehärteten Kupfer-Legierung mit zumindest 90 Gew% Kupfer bestehen, bevorzugt aus einer ausscheidungsgehärteten und/oder dispersionsgehärteten Kupfer-Legierung mit zumindest 97 Gew% Kupfer bestehen, besonders bevorzugt aus einer ausscheidungsgehärteten und/oder dispersionsgehärteten Kupfer-Legierung mit zumindest 99 Gew% Kupfer bestehen.

Ausscheidungsgehärtete und dispersionsgehärtete Kupfer-Legierungen mit hohem Kupferanteil sind besonders gut zur Herstellung von Prüfnadeln geeignet, da diese eine hohe elektrische Leitfähigkeit mit einer für Kupfer-Legierungen mit hohem Kupfer-Anteil relativ hohen Härte und Zugfestigkeit aufweisen.

Bevorzugt kann auch vorgesehen sein, dass die innere Kernschicht aus einer Palladium-Legierung enthaltend zumindest 30 Gew% Palladium besteht, bevorzugt aus einer Palladium-Legierung enthaltend zumindest 35 Gew% Palladium besteht, besonders bevorzugt aus einer Palladium-Kupfer-Silber-Legierung nach der EP 3 960 890 A1, nämlich aus einer Palladium-Kupfer-Silber-Legierung mit Palladium als Hauptkomponente wobei die Palladium-Kupfer-Silber-Legierung ein Gewichtsverhältnis von Palladium zu Kupfer von mindestens 1,05 und maximal 1,6 aufweist und ein Gewichtsverhältnis von Palladium zu Silber von mindestens 3 und maximal 6 aufweist und wobei die Palladium-Kupfer-Silber-Legierung mehr als 1 Gew% und bis maximal 6 Gew% Ruthenium, Rhodium oder Ruthenium und Rhodium enthält und als Rest Palladium, Kupfer und Silber und maximal 1 Gew% andere metallische Elemente einschließlich Verunreinigungen enthält.

Bevorzugt besteht die innere Kernschicht aus einer Palladium-Kupfer-Silber-Legierung enthaltend zumindest 35 Gew% Palladium, zumindest 20 Gew% Kupfer und zumindest 20 Gew% Silber, besonders bevorzugt aus einer Palladium-Kupfer-Silber-Legierung enthaltend 31 Gew% Kupfer und 29 Gew% Silber, bis zu 6 Gew% zumindest eines Elements, das ausgewählt ist aus der Gruppe, die aus Rhodium, Ruthenium und Rhenium besteht, und als Rest Palladium einschließlich Verunreinigungen besteht.

Besonders bevorzugt besteht die innere Kernschicht aus einer Palladium-Kupfer-Silber-Legierung nach der EP 3 960 890 A1. Dabei ist die besonders bevorzugte Palladium-Kupfer-Silber-Legierung in Absatz [0013] der EP 3 960 890 A1 beschrieben. Ganz besonders bevorzugte Ausführungsformen sind in den Absätzen [0021] bis [0048] und [0067] der EP 3 960 890 A1 beschrieben.

Derartige Palladium-Legierungen bewirken eine besonders hohe Zugfestigkeit und Warmfestigkeit des Verbundwerkstoffs und der daraus hergestellten Prüfnadeln und Bondbänder.

Es kann auch vorgesehen sein, dass der Verbundwerkstoff eine elektrische Leitfähigkeit gemessen mit einer Vierpunktmessmethode bei Raumtemperatur auf einer der zwei äußeren Deckschichten von zumindest 35% IACS (20,3 $10^6$ S/m) aufweist, bevorzugt von zumindest 40% IACS (23,2 106 S/m) aufweist, besonders bevorzugt von zumindest 45% IACS (26,1 $10^6$ S/m) aufweist.

Des Weiteren kann vorgesehen sein, dass der Verbundwerkstoff eine Vickers-Härte HV0,05 bei Raumtemperatur in den zwei Deckschichten von zumindest 170 aufweist, bevorzugt von zumindest 190 aufweist, besonders bevorzugt von zumindest 196 aufweist.

Ferner kann vorgesehen sein, dass der Verbundwerkstoff eine Zugfestigkeit bei Raumtemperatur parallel zur Ebene der inneren Kernschicht von zumindest 1000 MPa aufweist, bevorzugt von zumindest 1100 MPa aufweist.

Auch kann vorgesehen sein, dass der Verbundwerkstoff eine Streckgrenze bei Raumtemperatur parallel zur Ebene der inneren Kernschicht von zumindest 950 MPa aufweist, bevorzugt von zumindest 1050 MPa aufweist.

Diese physikalischen Eigenschaften des Verbundwerkstoffs können mit dem erfindungsgemäßen Verbundwerkstoff realisiert werden und bewirken vorteilhafte Materialeigenschaften für die daraus hergestellten Prüfnadeln und Bondbänder. Insbesondere bewirken die Kombinationen dieser physikalischen Eigenschaften sehr gute Eigenschaften für die Prüfnadeln und Bondbänder. Besonders die Kombination aus der hohen elektrischen Leitfähigkeit mit hoher Zugfestigkeit ist für Prüfnadeln und Bondbänder vorteilhaft.

Die elektrische Leitfähigkeit kann mit einer 4-Pol Messung des Spannungsabfalls am Prüfling bei definierter Länge mit einem Burster Resistomat 2316 bestimmt werden. Die Messung erfolgt auf den Hauptflächen des Verbundwerkstoffs mit einer Fläche mit einer Kantenlänge von 5 mm oder mehr, einer Stärke von 55 $\mu$m und einem Messstrom von 10 mA.

Ferner kann vorgesehen sein, dass der Verbundwerkstoff bei Raumtemperatur eine 0,2%-Dehngrenze $Rp_{0,2}$ (Elastizitätsgrenze) von mindestens 1000 MPa aufweist, bevorzugt von mindestens 1150 MPa aufweist, besonders bevorzugt von 1300 MPa aufweist.

Durch diese mechanischen und elektrischen Eigenschaften und insbesondere durch deren Kombination wird sichergestellt, dass der Verbundwerkstoff besonders gute elastische Eigenschaften und eine hohe elektrische Leitfähigkeit hat, um diesen als Prüfnadel oder Bondband einsetzen zu können.

Die 0,2%-Dehngrenze $Rp_{0,2}$ können mit einer Zwick Zugprüfmaschine Z250 bestimmt werden. Der Zugversuch kann an einem Verbundwerkstoff mit 50 $\mu$m Stärke und 13 mm Breite erfolgen und bezieht sich hierauf. Die Prüfgeschwindigkeit bezüglich der Streckgrenze $Rp_{0,2}$ beträgt 1 mm/min.

Des Weiteren kann vorgesehen sein, dass die ausscheidungsgehärtete und/oder dispersionsgehärtete Kupfer-Legierung eine ausscheidungsgehärtete und/oder dispersionsgehärtete Kupfer-Chrom-Legierung mit zumindest 98 Gew% Kupfer ist, insbesondere eine ausscheidungsgehärtete und/oder dispersionsgehärtete CuCr1Zr-Legierung mit mindestens 0,5 Gew% und maximal 1,2 Gew% Chrom und mit mindestens 0,03 Gew% bis maximal 0,3 Gew% Zirkon und dem Rest Kupfer einschließlich Verunreinigungen ist.

Auch kann vorgesehen sein, dass die ausscheidungsgehärtete und/oder dispersionsgehärtete Kupfer-Legierung eine ausscheidungsgehärtete Kupfer-Chrom-Titan-Legierung mit zumindest 99 Gew% Kupfer ist, insbesondere eine ausscheidungsgehärtete Kupfer-Chrom-Titan-Silizium-Legierung mit 0,3 Gew% Chrom, 0,1 Gew% Titan, 0,02 Gew% Si und dem Rest Kupfer einschließlich Verunreinigungen ist.

Ferner kann vorgesehen sein, dass die ausscheidungsgehärtete und/oder dispersionsgehärtete Kupfer-Legierung eine ausscheidungsgehärtete Kupfer-Chrom-Silber-Legierung mit zumindest 98 Gew% Kupfer ist, insbesondere eine ausscheidungsgehärtete Kupfer-Chrom-Silber-Eisen-Titan-Silizium-Legierung mit 0,5 Gew% Chrom, 0,2 Gew% Silber, 0,08 Gew% Eisen, 0,06 Gew% Titan, 0,03 Gew% Si und dem Rest Kupfer einschließlich Verunreinigungen ist.

Diese Kupfer-Legierungen werden erfindungsgemäß besonders bevorzugt.

Des Weiteren kann vorgesehen sein, dass die ausscheidungsgehärtete und/oder dispersionsgehärtete Kupfer-Legierung eine ausscheidungsgehärtete und/oder dispersionsgehärtete Kupfer-Silber-Legierung mit zumindest 90 Gew% Kupfer ist, insbesondere eine ausscheidungsgehärtete und/oder dispersionsgehärtete Kupfer-Silber-Legierung mit mindestens 3 Gew% bis maximal 7 Gew% Silber und dem Rest Kupfer einschließlich Verunreinigungen oder dem Rest Kupfer einschließlich Verunreinigungen und einschließlich 0 Gew% bis maximal 2 Gew% oxidischen Dispersoiden ist.

Eine solche Kupfer-Legierung mit 3 Gew% Silber (CuAg3) wird erfindungsgemäß besonders bevorzugt.

Ferner kann vorgesehen sein, dass die ausscheidungsgehärtete und/oder dispersionsgehärtete Silber-Legierung eine Silber-Kupfer-Legierung mit zumindest 70 Gew% Silber ist, bevorzugt eine Silber-Kupfer-Legierung mit mindestens 9 Gew% Kupfer und maximal 29 Gew% Kupfer und dem Rest Silber einschließlich Verunreinigungen ist, besonders bevorzugt eine Silber-Kupfer-Legierung mit 10 Gew% Kupfer und dem Rest Silber einschließlich Verunreinigungen ist oder eine Silber-Kupfer-Legierung mit 28 Gew% Kupfer und dem Rest Silber einschließlich Verunreinigungen ist.

Es kann auch vorgesehen sein, dass die Palladium-Legierung eine Palladium-Kupfer-Silber-Legierung mit Palladium als Hauptkomponente ist, wobei die Palladium-Kupfer-Silber-Legierung ein Gewichtsverhältnis von Palladium zu Kupfer von mindestens 1,05 und maximal 1,6 aufweist und ein Gewichtsverhältnis von Palladium zu Silber von mindestens 3 und maximal 6 aufweist und wobei die Palladium-Kupfer-Silber-Legierung mehr als 1 Gew% und bis maximal 6 Gew% Ruthenium, Rhodium oder Ruthenium und Rhodium und als Rest Palladium, Kupfer und Silber und maximal 1 Gew% andere metallische Elemente einschließlich Verunreinigungen enthält, bevorzugt weniger als 0,3 Gew% Iridium enthält.

Diese Palladium-Kupfer-Silber-Legierung wird erfindungsgemäß besonders bevorzugt.

Ein Gewichtsverhältnis von Palladium zu Kupfer von mindestens 1,05 und maximal 1,6 bedeutet, dass das Palladium mit einem Gewicht von mindestens 105% und maximal 160% des Gewichts des in der Palladium-Kupfer-Silber-Legierung enthaltenen Kupfers in der Palladium-Kupfer-Silber-Legierung enthalten ist.

Dementsprechend bedeutet ein Gewichtsverhältnis von Palladium zu Silber von mindestens 3 und maximal 6, dass das Palladium mit einem Gewicht von mindestens dem dreifachen und maximal dem sechsfachen des Gewichts des in der Palladium-Kupfer-Silber-Legierung enthaltenen Silbers in der Palladium-Kupfer-Silber-Legierung enthalten ist.

Des Weiteren kann vorgesehen sein, dass die Palladium-Legierung eine Palladium-Silber-Kupfer-Platin-Legierung ist, insbesondere eine Palladium-Silber-Kupfer-Platin-Zink-Gold-Legierung mit 38 Gew% Silber, 15 Gew% Kupfer, 1,5 Gew% Platin, 1 Gew% Zink, 0,5 Gew% Gold und dem Rest Palladium einschließlich Verunreinigungen ist oder eine Palladium-Silber-Kupfer-Platin-Gold-Zink-Legierung mit 30 Gew% Silber, 14 Gew% Kupfer, 10 Gew% Platin, 10 Gew% Gold, 1 Gew% Zink und dem Rest Palladium einschließlich Verunreinigungen ist.

Auch kann vorgesehen sein, dass die Palladium-Legierung eine Palladium-Kupfer-Silber-Ruthenium-Legierung, insbesondere eine Palladium-Kupfer-Silber-Ruthenium-Legierung mit 36,5 Gew% Kupfer, 10,5 Gew% Silber, 1,5 Gew% Ruthenium und dem Rest Palladium einschließlich Verunreinigungen ist oder eine Palladium-Kupfer-Silber-Ruthenium-Rhenium-Legierung mit 36,5 Gew% Kupfer, 10,5 Gew% Silber, 1,1 Gew% Ruthenium, 0,4 Gew% Rhenium und dem Rest Palladium einschließlich Verunreinigungen ist.

Des Weiteren kann vorgesehen sein, dass die Palladium-Legierung eine Palladium-Kupfer-Silber-Rhodium-Legierung ist, insbesondere eine Palladium-Kupfer-Silber-Rhodium-Legierung mit 36,5 Gew% Kupfer, 10,5 Gew% Silber, 1,5 Gew% Rhodium und dem Rest Palladium einschließlich Verunreinigungen ist.

Ferner kann vorgesehen sein, dass die Palladium-Legierung eine Palladium-Kupfer-Silber-Legierung ist, insbesondere eine Palladium-Kupfer-Silber-Legierung mit 31 Gew% Kupfer, 29 Gew% Silber und dem Rest Palladium einschließlich Verunreinigungen ist.

Es kann des Weiteren vorgesehen sein, dass die Palladium-Legierung eine Palladium-Silber-Kupfer-Legierung ist, insbesondere eine Palladium-Silber-Kupfer-Legierung mit 38 Gew% Silber, 15 Gew% Kupfer und dem Rest Palladium einschließlich Verunreinigungen ist.

Auch kann vorgesehen sein, dass die Platin-Legierung eine Platin-Nickel-Legierung ist, bevorzugt eine Platin-Nickel-Legierung mit mindestens 3 Gew% und maximal 10 Gew% Nickel und dem Rest Platin einschließlich Verunreinigungen ist, besonders bevorzugt eine Platin-Nickel-Legierung mit 5 Gew% Nickel und dem Rest Platin einschließlich Verunreinigungen ist. Bei den vorgenannten Legierungen ist das Element mit dem höchsten Gewichtsanteil in der Legierung stets als erstes genannt. Bevorzugt ist das Element mit dem zweithöchsten Gewichtsanteil in der Legierung als zweites genannt. Besonders bevorzugt ist das Element mit dem dritthöchsten Gewichtsanteil in der Legierung als drittes genannt. Ganz besonders bevorzugt sind bei den genannten Legierungen die genannten Legierungsbestandteile in ihrer Reihenfolge nach ihrem Gewichtsanteil geordnet.

Unter einer Hauptkomponente wird vorliegend das Element (in diesem Fall Palladium, Platin, Kupfer oder Silber) verstanden, das hauptsächlich, also mengenmäßig der größte Bestandteil ist, dass also beispielsweise mehr Palladium in einer Palladium-Kupfer-Silber-Legierung enthalten ist als Kupfer oder Silber.

Diese Legierungen sind zur Herstellung des erfindungsgemäßen Verbundwerkstoffs besonders gut geeignet.

Es kann vorgesehen sein, dass die ausscheidungsgehärtete und/oder dispersionsgehärtete Kupfer-Legierung bis zu 2 Gew% Ausscheidungen und/oder Dispersoide aufweist oder aufweisen, bevorzugt bis zu 1 Gew% Ausscheidungen und/oder Dispersoide aufweist oder aufweisen, die Ausscheidungen und/oder Dispersoide zu zumindest 95 Gew% bestehend aus zumindest einem der Elemente ausgewählt aus der Liste, die aus Chrom, Titan, Silizium, Eisen, Sauerstoff, Zirkon und Silber besteht.

Diese geringe Menge an Ausscheidungen und/oder Dispersoiden reicht aus, um die Härte der Kupfer-Legierung und gegebenenfalls auch der Silber-Legierung zu verbessern, ohne dass die elektrische Leitfähigkeit sehr stark reduziert würde.

Der Anteil an Ausscheidungen und/oder Dispersoiden kann bestimmt werden, indem ein Querschliff der Kupfer-Legierung mittels Rasterelektronenmikroskopie oder auch Lichtmikroskopie hinsichtlich des Flächenverhältnisses von Ausscheidungen und/oder Dispersoiden zu der Gesamtfläche der Kupfer-Legierung ausgewertet wird, wobei hierzu die Dichte der Ausscheidungen und/oder Dispersoide und der sie umgebenden Matrix berücksichtigt werden muss. Die Dichte beispielsweise kann anhand einer Zusammensetzungsanalyse mittels Energiedispersiver oder Wellenlängendispersiver Röntgenanalyse (EDX oder WDX) oder mittels Röntgenfluoreszenz bestimmt werden.

Es kann vorgesehen sein, dass die ausscheidungsgehärtete und/oder dispersionsgehärtete Silber-Legierung bis zu 2 Gew% Ausscheidungen und/oder Dispersoide aufweist oder aufweisen, bevorzugt bis zu 1 Gew% Ausscheidungen und/oder Dispersoide aufweist oder aufweisen, die Ausscheidungen und/oder Dispersoide zu zumindest 95 Gew% bestehend aus zumindest einem der Elemente ausgewählt aus der Liste, die aus Chrom, Titan, Silizium, Eisen, Sauerstoff, Zirkon und Kupfer besteht.

Ferner kann vorgesehen sein, dass die innere Kernschicht aus einer ausscheidungsgehärteten und/oder dispersionsgehärteten Palladium-Legierung oder aus einer ausscheidungsgehärteten und/oder dispersionsgehärteten Platin-Legierung besteht.

Hierdurch wird die Zugfestigkeit des Verbundwerkstoffs und die Standfestigkeit der Nadelspitze der daraus hergestellten Prüfnadeln verbessert. Bevorzugt besteht die innere Kernschicht aus einer ausscheidungsgehärteten und/oder dispersionsgehärteten Palladium-Legierung.

Die der vorliegenden Erfindung zugrundeliegenden Aufgaben werden auch gelöst durch eine Prüfnadel oder ein Bondband bestehend aus einem Streifen eines zuvor beschriebenen Verbundwerkstoffs.

Die Prüfnadel und das Bondband profitieren von den vorteilhaften physikalischen Eigenschaften des Verbundwerkstoffs.

Dabei kann vorgesehen sein, dass die Prüfnadel eine Spitze aufweist, die aus dem Material der inneren Kernschicht besteht.

Hierdurch wird eine hohe Standfestigkeit der Prüfnadel erreicht. Die Prüfnadel mit dieser Spitze kann folglich sehr oft verwendet werden, ohne dass sie ausgetauscht oder sehr häufig aufbereitet werden muss.

Die der vorliegenden Erfindung zugrundeliegenden Aufgaben werden ferner gelöst durch ein Prüfnadelarray aufweisend eine Mehrzahl von nebeneinander angeordneten vorgenannten Prüfnadeln.

Die der vorliegenden Erfindung zugrundeliegenden Aufgaben werden auch gelöst durch die Verwendung eines zuvor beschriebenen Verbundwerkstoffs oder einer zuvor beschriebenen Prüfnadel oder eines zuvor beschriebenen Prüfnadelarrays zum Prüfen von elektrischen Kontakten oder zur elektrischen Kontaktierung oder zur Herstellung eines Schleifkontakts.

Die der vorliegenden Erfindung zugrundeliegenden Aufgaben werden des Weiteren gelöst durch ein Verfahren zur Herstellung eines Verbundwerkstoffs aus zwei Metall-Legierungen, wobei der Verbundwerkstoff zur Herstellung von Prüfnadeln zur elektronischen Prüfung von Halbleiterelementen geeignet und vorgesehen ist und wobei das Verfahren durch die folgenden, chronologisch aufeinander folgenden Schritte gekennzeichnet ist:

A) Bereitstellen eines ersten Bands aus einer Palladium-Legierung mit zumindest 30 Gew% Palladium oder aus einer Platin-Legierung mit zumindest 30 Gew% Platin und eines zweiten Bands aus einer ausscheidungsgehärteten und/oder dispersionsgehärteten Kupfer-Legierung mit zumindest 90 Gew% Kupfer oder aus einer ausscheidungsgehärteten und/oder dispersionsgehärteten Silber-Legierung mit zumindest 70 Gew% Silber und eines dritten Bands aus einer ausscheidungsgehärteten und/oder dispersionsgehärteten Kupfer-Legierung mit zumindest 90 Gew% Kupfer oder aus einer ausscheidungsgehärteten und/oder dispersionsgehärteten Silber-Legierung mit zumindest 70 Gew% Silber,

B) Anordnen des ersten Bands zwischen das zweite Band und das dritte Band und Aneinanderlegen des ersten Bands an das zweite Band und an das dritte Band, und

C) Verbinden des ersten Bands mit dem zweiten Band und dem dritten Band durch Walzplattieren der aneinander angelegten Bänder, wobei durch das Walzplattieren ein zusammenhängender bandförmiger Verbundwerkstoff aus den Materialien des ersten Bands, des zweiten Bands und der dritten Bands erzeugt wird.

Bevorzugt wird beim Walzplattieren die Dicke des ersten Bands, des zweiten Bands und des dritten Bands reduziert.

Das Walzplattieren kann in mehreren Schritten durchgeführt werden, wobei die Dicke des Verbunds bei jedem Schritt reduziert wird.

Bei erfindungsgemäßen Verfahren kann vorgesehen sein, dass nach Schritt C) ein Schritt D) erfolgt:

D) Temperaturbehandlung des in Schritt C) erzeugten Verbunds, wobei bei der Temperaturbehandlung das Material des ersten Bands ausscheidungsgehärtet und/oder dispersionsgehärtet wird.

Durch die nachgelagerte Temperaturbehandlung können die Bänder zuvor gut miteinander durch Walzen verbunden werden.

Ferner kann vorgesehen sein, mit dem Verfahren ein zuvor beschriebener Verbundwerkstoff oder mit dem Verfahren durch Schneiden oder Stanzen des Verbundwerkstoffs zumindest eine zuvor beschriebene Prüfnadel oder zumindest ein zuvor beschriebenes Bondband hergestellt wird, bevorzugt mit dem Verfahren durch Schneiden oder Stanzen eine Vielzahl von zuvor beschriebenen Prüfnadeln oder Bondbändern hergestellt werden.

Der Erfindung liegt die überraschende Erkenntnis zugrunde, dass eine Schicht aus einer festen und harten Palladium-Legierung oder Platin-Legierung auf beiden Seiten mit einer ausscheidungsgehärteten Kupfer-Legierung und/oder Silber-Legierung mit höherer elektrischer Leitfähigkeit beschichtet werden kann, um einen sandwichartige und bandförmigen Verbundwerkstoff zu erzeugen, dessen mechanische Eigenschaften im Vergleich zu einer mit Rein-Kupfer oder Rein-Silber beschichteten Palladium-Legierung oder Platin-Legierung bezüglich der Zugfestigkeit und Warmzugfestigkeit sowie der Härte verbessert sind, aber gleichzeitig eine deutliche Erhöhung der elektrischen Leitfähigkeit im Vergleich zu einer reinen harten Palladium-Legierung oder Platin-Legierung erreicht werden. Es wurde im Rahmen der vorliegenden Erfindung überraschend gefunden, dass sich eine derartige Beschichtung mit einer ausscheidungsgehärteten Kupfer-Legierung und/oder Silber-Legierung mit Hilfe von Walzplattier-Verfahren realisieren lässt, die mit einer galvanischen Beschichtung nicht zu fertigen wäre. Die vorliegende Erfindung beruht auch auf der Erkenntnis, dass sich die Kernschicht und die zwei äußeren Deckschichten bei ähnlicher Härte gut miteinander durch Walzplattieren fügen lassen.

Der erfindungsgemäß bevorzugte Verbundwerkstoff aus einer Kupfer- und einer Palladium-Legierung für Leitungswerkstoffe oder Prüfnadeln kombiniert in vorteilhafter Weise die positiven Eigenschaften von Kupfer-Legierungen (hohe elektrische Leitfähigkeit) und Palladium-Legierungen (hohe Warmfestigkeit und gute Federeigenschaften). Damit erhält man einen Werkstoff der eine bessere Leitfähigkeit hat als die bestehenden Palladium-Legierungen (Hera 6321® oder Paliney H3C®) und eine bessere Warmfestigkeit und Gesamthärte als CuAg7. Die verwendeten Kupfer-Legierungen haben die vierfache Festigkeit von Rein-Kupfer bei ca. 80 % der elektrischen Leitfähigkeit von Rein-Kupfer und damit deutlich bessere Gesamteigenschaften. Diese beim Walzplattieren eingesetzten Legierungen können mit galvanischen Prozessen, die sich in der Regel auf Reinmetalle und wenige ausgewählte Legierungen beschränken, nicht abgeschieden werden.

Galvanisch können auch mehrere verschiedene Schichten aus verschiedenen Metallen und Edelmetallen aufgebracht werden, um eine vorteilhafte Eigenschaftskombination zu erreichen. Allerdings können auf diese Weise keine ausscheidungshärtenden Legierungen abgeschieden werden und der Prozess wird auf diese Weise sehr aufwendig. Bei einer abschließenden Wärmebehandlung besteht zudem die Gefahr von Diffusion was sich aufgrund von Mischkristallbildung negativ auf die elektrische Leitfähigkeit auswirkt.

Denkbar ist auch eine galvanisch mit Kupfer beschichtete Palladium-Legierung durch weiteres Walzen zu kaltverfestigen. Allerdings sind hier keine konsistenten Eigenschaften zu erwarten, da Kupfer- und Palladium-Legierungen deutlich verschiedene Härten aufweisen was eine ungleichmäßige Umformung zur Folge hat.

Im Folgenden werden Ausführungsbeispiele der Erfindung anhand von vier schematisch dargestellten Figuren und einem Ablaufdiagramm erläutert, ohne jedoch dabei die Erfindung zu beschränken. Dabei zeigt:

Figur 1: eine schematische Querschnittansicht durch einen Ausschnitt eines erfindungsgemäßen Verbundwerkstoffs;

Figur 2: eine schematische perspektivische Querschnittansicht durch einen Ausschnitt des erfindungsgemäßen Verbundwerkstoffs nach Figur 1;

Figur 3: eine lichtmikroskopische Aufnahme eines polierten Querschliffs eines erfindungsgemäßen Verbundwerkstoffs;

Figur 4: eine lichtmikroskopische Aufnahme eines polierten Querschliffs eines weiteren erfindungsgemäßen Verbundwerkstoffs; und

Figur 5: ein Ablaufdiagramm eines erfindungsgemäßen Verfahrens.

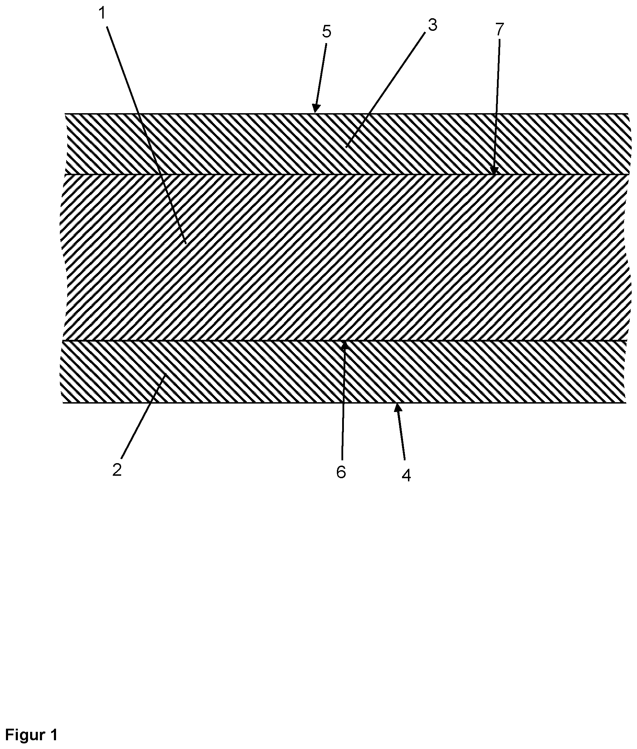

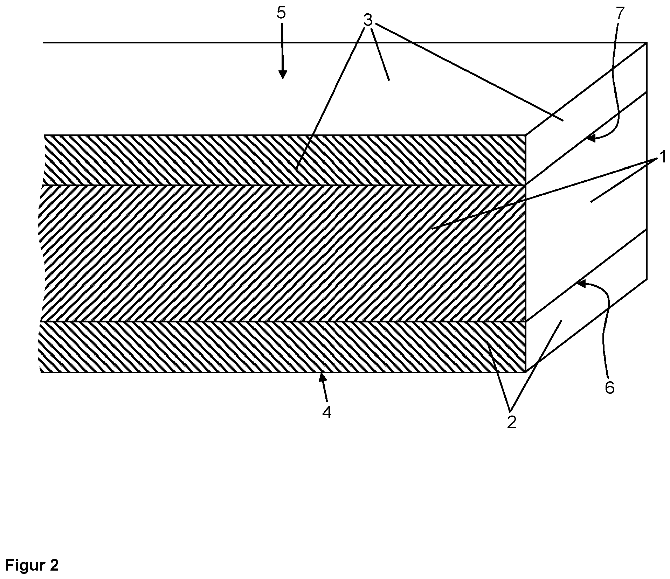

Die Figuren 1 und 2 zeigen schematische Querschnittansichten durch einen erfindungsgemäßen Verbundwerkstoff. Die Querschnittsflächen sind schraffiert dargestellt.

Der Verbundwerkstoff hat eine innere Kernschicht 1 und zwei äußere Deckschichten 2, 3.

Die innere Kernschicht 1 besteht aus einer Palladium-Legierung mit zumindest 30 Gew% Palladium oder aus einer Platin-Legierung mit zumindest 30 Gew% Platin. Jeder der zwei äußeren Deckschichten 2, 3 kann aus einer ausscheidungsgehärteten und/oder dispersionsgehärteten Kupfer-Legierung mit zumindest 90 Gew% Kupfer oder aus einer ausscheidungsgehärteten und/oder dispersionsgehärteten Silber-Legierung mit zumindest 70 Gew% Silber bestehen.

Bevorzugt besteht die innere Kernschicht 1 aus einer Palladium-Legierung wie sie in der EP 3 960 890 A1 beschrieben ist.

Bevorzugt bestehen die zwei äußeren Deckschichten 2, 3 aus einer ausscheidungsgehärteten und/oder dispersionsgehärteten Kupfer-Legierung mit zumindest 90 Gew% Kupfer, besonders bevorzugt aus einer ausscheidungsgehärteten Kupfer-Legierung mit zumindest 98 Gew% Kupfer.

Die innere Kernschicht 1 und die zwei äußeren Deckschichten 2, 3 können durch Walzplattieren von Bändern des jeweiligen Materials fest miteinander verbunden und unmittelbar aneinander gefügt sein.

Der Verbundwerkstoff weist zwei einander gegenüberliegende Hauptflächen 4, 5 auf, die durch die nach außen gerichteten Oberflächen der Deckschichten 2, 3 gebildet werden. Die Hauptflächen 4, 5 können planparallel zueinander angeordnet sein. Der Verbundwerkstoff kann in guter Näherung einen flachen Quader bilden, wobei die Hauptflächen 4, 5 vorzugsweise größer sind, als alle anderen Oberflächen des Verbundwerkstoffs zusammen.

Die innere Kernschicht 1 und die zwei äußeren Deckschichten 2, 3 sind über Grenzflächen 6, 7 aneinander gefügt. Im Bereich der Grenzflächen 6, 7 kann es zu einer Durchmischung der Materialien der zwei äußeren Deckschichten 2, 3 und der inneren Kernschicht 1 kommen.

Ein erfindungsgemäßer Verbundwerkstoff kann beispielsweise wie folgt hergestellt werden:

Ein Sandwich aus drei Blechen mit einer ausscheidungsgehärteten und/oder dispersionsgehärteten Kupfer-Legierung und/oder einer ausscheidungsgehärteten und/oder dispersionsgehärteten Silber-Legierung oben und unten sowie einer Platin-Legierung oder einer Palladium-Legierung (insbesondere einem Palladium-Superlattice) in der Mitte wird in einem Walzstich mit ca. 60-75 % Stichabnahme miteinander verwalzt, wobei diese drei Bleche kaltverschweißen und einen Verbund bilden. Die Härten der Werkstoffe sind dabei sehr ähnlich, was dadurch erreicht wird, dass die ausscheidungsgehärtete und/oder dispersionsgehärtete Kupfer-Legierung und/oder die ausscheidungsgehärtete und/oder dispersionsgehärtete Silber-Legierung im ausgehärteten Zustand mit der Palladium-Legierung oder Platin-Legierung (insbesondere mit einer Palladium-Superlattice-Legierung nach der EP 3 960 890 A1) im lösungsgeglühten Zustand verwalzt wird oder werden. Nach dem Walzen an die gewünschte Dicke von 30-60 $\mu$m wird die Härte und die elektrische Leitfähigkeit der Platin-Legierung oder Palladium-Legierung durch ein Ordnungsglühen bei 380 °C für 5 Minuten (vorzugsweise unter Vakuum oder unter Schutzgas) eingestellt. Dabei erhöht sich die elektrische Leitfähigkeit und Festigkeit der Palladium-Legierung oder der Platin-Legierung erheblich (siehe das Palladium-Superlattice nach der EP 3 960 890 A1), ohne dass die mechanischen und elektrischen Eigenschaften der Kupfer-Legierung und/oder Silber-Legierung negativ beeinflusst werden. Die Herstellung der Palladium-Legierung kann ebenfalls analog dem in der EP 3 960 890 A1 geschilderten Verfahren erfolgen.

Zum Durchführen von Vergleichsmessungen wurden ein Blech einer Palladium-Legierung mit der Zusammensetzung 36,5 Gew% Kupfer, 10,5 Gew% Silber, 1,5 Gew% Ruthenium und dem Rest Palladium einschließlich weniger als 0,1 Gew% Verunreinigungen und hergestellt nach der EP 3 960 890 A1 sowie zwei Bleche einer ausscheidungsgehärteten Kupfer-Legierung Wieland-K75 (C18070) mit 0,3 Gew% Chrom, 0,1 Gew% Titan, 0,02 Gew% Silizium und dem Rest Kupfer miteinander verwalzt. Anschließend wurde der Verbund auf eine Dicke von 54 $\mu$m gewalzt.

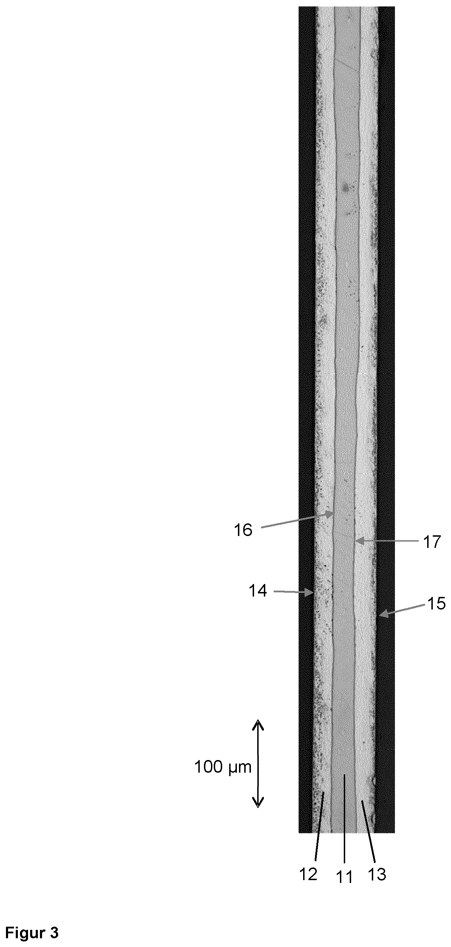

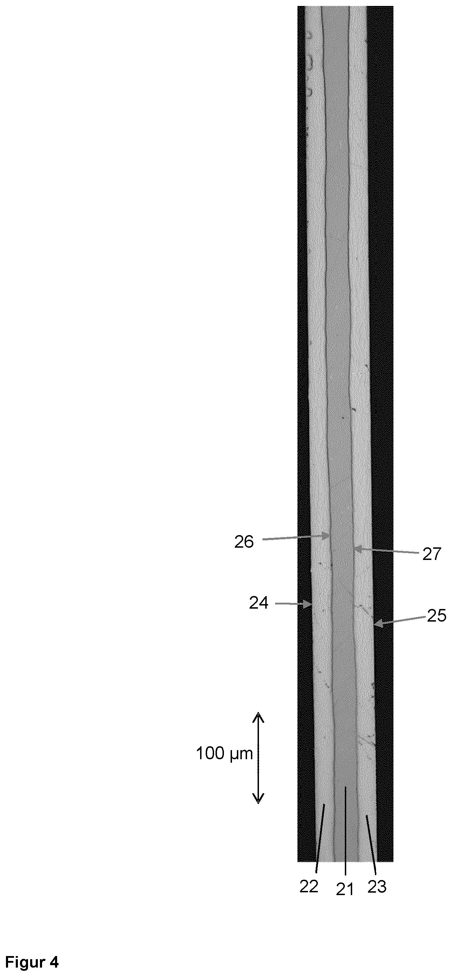

Zwei derartig hergestellte erfindungsgemäße Verbundwerkstoffe sind in den Figuren 3 und 4 als lichtmikroskopische Aufnahmen von Querschliffen der bandförmigen Verbundwerkstoffe gezeigt. Die Aufnahmen wurden mit einem Lichtmikroskop Leica DM 6 mit Auflicht erstellt. Die Verbundwerkstoffe wurden dazu in Epoxidharz eingebettet und senkrecht zur der Walzebene geschliffen und poliert. Das Epoxidharz erscheint in den Figuren 3 und 4 schwarz und gehört nicht zum Verbundwerkstoff.

Der in Figur 3 gezeigte Verbundwerkstoff A weist demzufolge eine innere Kernschicht 11 aus einer Palladium-Legierung mit der Zusammensetzung 36,5 Gew% Kupfer, 10,5 Gew% Silber, 1,5 Gew% Ruthenium und dem Rest Palladium einschließlich weniger als 0,1 Gew% Verunreinigungen auf. Die Kernschicht 11 ist auf beiden Seiten von zwei äußeren Deckschichten 12, 13 aus einer ausscheidungsgehärteten Kupfer-Legierung Wieland-K75 (C18070) mit 0,3 Gew% Chrom, 0,1 Gew% Titan, 0,02 Gew% Silizium und dem Rest Kupfer umgeben. Die zwei äußeren Deckschichten 12, 13 begrenzen den Verbundwerkstoff A mit jeweils einer Hauptfläche 14, 15, die den größten Teil der Oberfläche des Verbundwerkstoffs A bildet. Durch das Walzen sind die innere Kernschicht 11 und die zwei äußeren Deckschichten 12, 13 miteinander gefügt und fest verbunden. Eine Zwischenschicht existiert nicht. Die innere Kernschicht 11 und die zwei äußeren Deckschichten 12, 13 sind über Grenzflächen 16, 17 aneinander gefügt. Im Bereich der Grenzflächen 16, 17 kann es zu einer Durchmischung der Materialien der zwei äußeren Deckschichten 12, 13 und der inneren Kernschicht 11 kommen. Der in Figur 4 gezeigte Verbundwerkstoff B weist analog eine innere Kernschicht 21 aus einer Palladium-Legierung mit der Zusammensetzung 36,5 Gew% Kupfer, 10,5 Gew% Silber, 1,5 Gew% Ruthenium und dem Rest Palladium einschließlich weniger als 0,1 Gew% Verunreinigungen auf. Die Kernschicht 21 ist auf beiden Seiten von zwei äußeren Deckschichten 22, 23 aus einer ausscheidungsgehärteten Kupfer-Legierung Wieland-K75 (C18070) mit 0,3 Gew% Chrom, 0,1 Gew% Titan, 0,02 Gew% Silizium und dem Rest Kupfer umgeben. Die zwei äußeren Deckschichten 22, 23 begrenzen den Verbundwerkstoff B mit jeweils einer Hauptfläche 24, 25, die den größten Teil der Oberfläche des Verbundwerkstoffs B bildet. Durch das Walzen sind die innere Kernschicht 21 und die zwei äußeren Deckschichten 22, 23 miteinander gefügt und fest verbunden. Eine Zwischenschicht existiert auch hier nicht. Die innere Kernschicht 21 und die zwei äußeren Deckschichten 22, 23 sind über Grenzflächen 26, 27 aneinander gefügt. Im Bereich der Grenzflächen 26, 27 kann es zu einer Durchmischung der Materialien der zwei äußeren Deckschichten 22, 23 und der inneren Kernschicht 21 kommen.

Anschließend wurden die elektrische Leitfähigkeit mit einer Vierpunktmessung auf einer der durch die ausscheidungsgehärtete Kupfer-Legierung gebildeten Hauptflächen 14, 15, 24, 25 der Verbundwerkstoffe A und B bestimmt. Die Vierpunkt-Messmethode, auch Vierpunktmessung oder Vierspitzenmessung, ist ein Verfahren, um den Flächenwiderstand, also den elektrischen Widerstand einer Oberfläche oder dünnen Schicht, zu ermitteln. Bei dem Verfahren werden vier Messspitzen in einer Reihe auf die Oberfläche der Hauptfläche gebracht, wobei über die beiden äußeren Messspitzen ein bekannter Strom fließt und mit den beiden inneren Messspitzen der Potentialunterschied, das heißt, die elektrische Spannung zwischen diesen beiden inneren Messspitzen, gemessen wird. Da das Verfahren auf dem Prinzip der Vierleitermessung beruht, ist es weitgehend unabhängig vom Übergangswiderstand zwischen den Messspitzen und der Oberfläche (Prinzip Thomson-Brücke). Benachbarte Messspitzen haben jeweils den gleichen Abstand. Der Flächenwiderstand R ergibt sich aus der gemessenen Spannung U und dem Strom *I* nach der Formel:

$$R = \frac{\pi}{\ln 2} \frac{U}{I}$$

Um aus dem Flächenwiderstand *R* den spezifischen Widerstand $\rho$ des Schichtmaterials zu errechnen, multipliziert man ihn mit der Dicke *d* (Schichtdicke) der Folie:

$$\rho = d\,R$$

Die elektrische Leitfähigkeit ergibt sich aus dem Kehrwert des spezifischen Widerstands.

Die Härte (HV0,05 - Vickers Härteprüfung nach DIN EN ISO 6507-1:2018 bis -4:2018 mit einer Prüfkraft von 0,4905 N (0,05 Kilopond)), die Festigkeit wurde mittels Zugversuchen untersucht. Die in den Figuren 3 und 4 gezeigten Verbundwerkstoffe A und B wurden hergestellt und untersucht.

Für den Vergleich wurde auch eine Palladium-Kupfer-Silber-Legierung mit dem Produktnamen Hera 6321 mit der Zusammensetzung 39 Gew% Pd, 31 Gew% Cu, 29 Gew% Ag, 0,9 Gew% Zn und 0,1 Gew% B untersucht.

Tabelle 1: Nachfolgend sind die Messergebnisse der elektrischen Leitfähigkeit (IACS) und der Härte zu den untersuchten Legierungen aufgelistet

| | IACS [%] | Härte [HV0,05] |
|---|---|---|
| Hera 6321 | 9-12 | 400-500 |
| Verbundwerkstoff A | 56,5 | 200 |
| Verbundwerkstoff B | 55,8 | 197 |

Die Messungen der Verbundwerkstoffe A und B erfolgten an Blechen der Stärke 54 $\mu$m. Die Messung der Hera-6321-Legierung erfolgte an einem Blech der Stärke 54 $\mu$m.

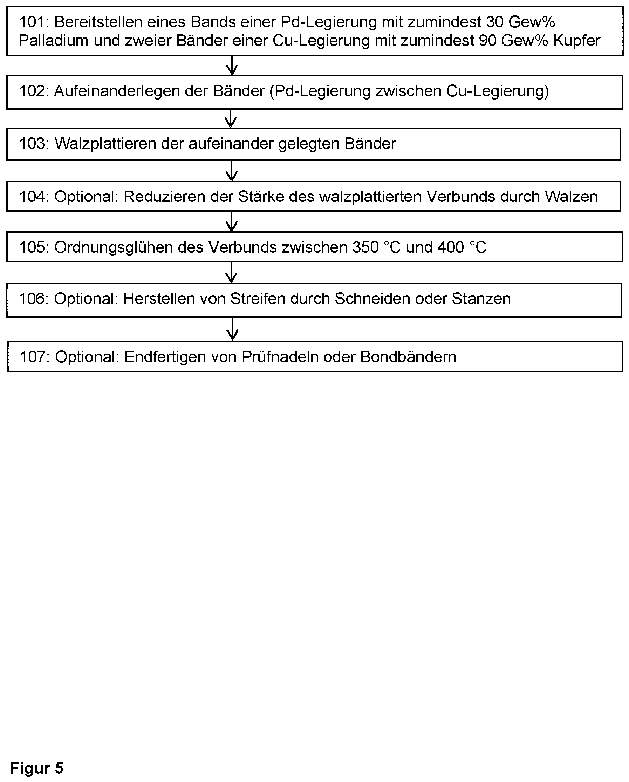

Im Folgenden wird anhand von Figur 5 zusammen mit den Figuren 1 und 2 der Ablauf eines erfindungsgemäßen Verfahrens geschildert.

In einem ersten Arbeitsschritt 101 können ein Band aus einer Palladium-Legierung mit zumindest 30 Gew% Palladium und zwei Bänder einer ausscheidungsgehärteten und/oder dispersionsgehärteten Kupfer-Legierung mit zumindest 90 Gew% Kupfer bereitgestellt oder hergestellt werden.

In einem zweiten Arbeitsschritt 102 kann das Band aus der Palladium-Legierung zwischen die Bänder aus der Kupfer-Legierung gelegt werden.

In einem dritten Arbeitsschritt 103 können die Bänder durch Walzplattieren miteinander gefügt werden, wobei die Stärke der Bänder beim Walzplattieren reduziert wird.

In einem optionalen vierten Arbeitsschritt 104 kann die Stärke des so erzeugten Verbunds durch weiteres Walzen in einem oder in mehreren Schritten auf die Zielstärke (beispielsweise auf 50 $\mu$m) reduziert werden.

In einem fünften Arbeitsschritt 105 kann der so hergestellte Verbund ordnungsgeglüht werden (beispielsweise bei 380 °C für 5 Minuten), um die gewünschte Härte der mittleren Kernschicht 1 aus der Palladium-Legierung einzustellen.

In einem optionalen sechsten Arbeitsschritt 106 kann der Verbundwerkstoff in Streifen geschnitten oder gestanzt werden.

Anschließend kann optional in einem siebten Arbeitsschritt 107 eine Endfertigung von Prüfnadeln oder Bondbändern erfolgen. Hierzu können beispielsweise die Kernschichten 1 der Streifen als Spitzen der Prüfnadeln herausgearbeitet werden.

**Bezugszeichenliste**

| 1, 11, 21 | Innere Kernschicht |
|---|---|
| 2, 12, 22 | Äußere Deckschicht |
| 3, 13, 23 | Äußere Deckschicht |
| 4, 14, 24 | Hauptfläche |
| 5, 15, 25 | Hauptfläche |
| 6, 16, 26 | Grenzfläche |
| 7, 17, 27 | Grenzfläche |
| 101 | erster Arbeitsschritt |
| 102 | zweiter Arbeitsschritt |
| 103 | dritter Arbeitsschritt |
| 104 | vierter Arbeitsschritt |
| 105 | fünfter Arbeitsschritt |
| 106 | sechster Arbeitsschritt |
| 107 | siebter Arbeitsschritt |

**Patentansprüche**

1. Verbundwerkstoff zur Herstellung von Prüfnadeln zur elektronischen Prüfung von Halbleiterelementen, wobei der Verbundwerkstoff bandförmig ist und von zwei zueinander parallelen Hauptflächen (4, 5, 14, 15, 24, 25) begrenzt ist, wobei der Verbundwerkstoff senkrecht zu den parallelen Hauptflächen (4, 5, 14, 15, 24, 25) geschichtet ist und eine Sandwichbauweise mit einer inneren Kernschicht (1, 11, 21) und zwei äußeren Deckschichten (2, 3, 12, 13, 22, 23) aufweist, wobei die innere Kernschicht (1, 11, 21) zwischen den zwei äußeren Deckschichten (2, 3, 12, 13, 22, 23) angeordnet ist und die innere Kernschicht (1, 11, 21) auf zwei gegenüberliegenden Seiten mit den zwei äußeren Deckschichten (2, 3, 12, 13, 22, 23) fest verbunden ist, wobei die zwei äußeren Deckschichten (2, 3, 12, 13, 22, 23) die parallelen Hauptflächen (4, 5, 14, 15, 24, 25) bilden, wobei die innere Kernschicht (1, 11, 21) aus einer Palladium-Legierung mit zumindest 30 Gew% Palladium oder aus einer Platin-Legierung mit zumindest 30 Gew% Platin besteht und wobei die zwei äußeren Deckschichten (2, 3, 12, 13, 22, 23) aus einer ausscheidungsgehärteten und/oder dispersionsgehärteten Kupfer-Legierung mit zumindest 90 Gew% Kupfer oder aus einer ausscheidungsgehärteten und/oder dispersionsgehärteten Silber-Legierung mit zumindest 70 Gew% Silber oder aus einer ausscheidungsgehärteten und/oder dispersionsgehärteten Kupfer-Legierung mit zumindest 90 Gew% Kupfer und aus einer ausscheidungsgehärteten und/oder dispersionsgehärteten Silber-Legierung mit zumindest 70 Gew% Silber bestehen.

2. Verbundwerkstoff nach Anspruch 1, **dadurch gekennzeichnet, dass**

   die innere Kernschicht (1, 11, 21) unmittelbar mit den zwei äußeren Deckschichten (2, 3, 12, 13, 22, 23) verbunden ist, und/oder
   der Verbundwerkstoff aus der inneren Kernschicht (1, 11, 21) und den äußeren Deckschichten (2, 3, 12, 13, 22, 23) besteht.

3.  Verbundwerkstoff nach einem der vorangehenden Ansprüche, **dadurch gekennzeichnet, dass**
    die zwei äußeren Deckschichten (2, 3, 12, 13, 22, 23) aus einer ausscheidungsgehärteten und/oder dispersionsgehärteten Kupfer-Legierung mit zumindest 90 Gew% Kupfer bestehen, bevorzugt aus einer ausscheidungsgehärteten und/oder dispersionsgehärteten Kupfer-Legierung mit zumindest 97 Gew% Kupfer bestehen, besonders bevorzugt aus einer ausscheidungsgehärteten und/oder dispersionsgehärteten Kupfer-Legierung mit zumindest 99 Gew% Kupfer bestehen.

4.  Verbundwerkstoff nach einem der vorangehenden Ansprüche, **dadurch gekennzeichnet, dass**
    die innere Kernschicht (1, 11, 21) aus einer Palladium-Legierung enthaltend zumindest 30 Gew% Palladium besteht, bevorzugt aus einer Palladium-Legierung enthaltend zumindest 35 Gew% Palladium besteht, besonders bevorzugt aus einer Palladium-Kupfer-Silber-Legierung mit Palladium als Hauptkomponente wobei die Palladium-Kupfer-Silber-Legierung ein Gewichtsverhältnis von Palladium zu Kupfer von mindestens 1,05 und maximal 1,6 aufweist und ein Gewichtsverhältnis von Palladium zu Silber von mindestens 3 und maximal 6 aufweist und wobei die Palladium-Kupfer-Silber-Legierung mehr als 1 Gew% und bis maximal 6 Gew% Ruthenium, Rhodium oder Ruthenium und Rhodium enthält und als Rest Palladium, Kupfer und Silber und maximal 1 Gew% andere metallische Elemente einschließlich Verunreinigungen enthält.

5.  Verbundwerkstoff nach einem der vorangehenden Ansprüche, **dadurch gekennzeichnet, dass**

    der Verbundwerkstoff eine elektrische Leitfähigkeit gemessen mit einer Vierpunktmessmethode bei Raumtemperatur auf einer der zwei äußeren Deckschichten (2, 3, 12, 13, 22, 23) von zumindest 35% IACS (20,3 $10^6$ S/m) aufweist, bevorzugt von zumindest 40% IACS (23,2 $10^6$ S/m) aufweist, besonders bevorzugt von zumindest 45% IACS (26,1 $10^6$ S/m) aufweist, wobei die elektrische Leitfähigkeit mit einer 4-Pol Messung des Spannungsabfalls am Prüfling bei definierter Länge mit einem Burster Resistomat 2316 bestimmt wird und die Messung auf den Hauptflächen des Verbundwerkstoffs mit einer Fläche mit einer Kantenlänge von 5 mm oder mehr, einer Stärke von 55 $\mu$m und einem Messstrom von 10 mA erfolgt, und/oder
    der Verbundwerkstoff eine Vickers-Härte HV0,05 (HV0,05 - Vickers Härteprüfung nach DIN EN ISO 6507-1:2018 bis -4:2018 mit einer Prüfkraft von 0,4905 N (0,05 Kilopond)) bei Raumtemperatur in den zwei Deckschichten (2, 3, 12, 13, 22, 23) von zumindest 170 aufweist, bevorzugt von zumindest 190 aufweist, besonders bevorzugt von zumindest 196 aufweist, und/oder
    der Verbundwerkstoff eine Zugfestigkeit bei Raumtemperatur parallel zur Ebene der inneren Kernschicht (1, 11, 21) von zumindest 1000 MPa aufweist, die durch Zugversuche mit einer Zwick Zugprüfmaschine Z250 bestimmt werden an einem Verbundwerkstoff mit 50 $\mu$m Stärke und 13 mm Breite und wobei die Prüfgeschwindigkeit 1 mm/min beträgt, bevorzugt von zumindest 1100 MPa aufweist, und/oder
    der Verbundwerkstoff eine Streckgrenze bei Raumtemperatur parallel zur Ebene der inneren Kernschicht (1, 11, 21) von zumindest 950 MPa aufweist, bevorzugt von zumindest 1050 MPa aufweist, wobei die 0,2%-Dehngrenze Rp0,2 mit einer Zwick Zugprüfmaschine Z250 bestimmt wird, an einem Verbundwerkstoff mit 50 $\mu$m Stärke und 13 mm Breite erfolgt und wobei die Prüfgeschwindigkeit bezüglich der Streckgrenze Rp0,2 1 mm/min beträgt.

6.  Verbundwerkstoff nach einem der vorangehenden Ansprüche, **dadurch gekennzeichnet, dass**

    die ausscheidungsgehärtete und/oder dispersionsgehärtete Kupfer-Legierung eine ausscheidungsgehärtete und/oder dispersionsgehärtete Kupfer-Chrom-Legierung mit zumindest 98 Gew% Kupfer ist, insbesondere eine ausscheidungsgehärtete und/oder dispersionsgehärtete CuCr1Zr-Legierung mit mindestens 0,5 Gew% und maximal 1,2 Gew% Chrom und mit mindestens 0,03 Gew% bis maximal 0,3 Gew% Zirkon und dem Rest Kupfer einschließlich Verunreinigungen ist, oder
    die ausscheidungsgehärtete und/oder dispersionsgehärtete Kupfer-Legierung eine ausscheidungsgehärtete Kupfer-Chrom-Titan-Legierung mit zumindest 99 Gew% Kupfer ist, insbesondere eine ausscheidungsgehärtete Kupfer-Chrom-Titan-Silizium-Legierung mit 0,3 Gew% Chrom, 0,1 Gew% Titan, 0,02 Gew% Si und dem Rest Kupfer einschließlich Verunreinigungen ist, oder
    die ausscheidungsgehärtete und/oder dispersionsgehärtete Kupfer-Legierung eine ausscheidungsgehärtete Kupfer-Chrom-Silber-Legierung mit zumindest 98 Gew% Kupfer ist, insbesondere eine ausscheidungsgehärtete Kupfer-Chrom-Silber-Eisen-Titan-Silizium-Legierung mit 0,5 Gew% Chrom, 0,2 Gew% Silber, 0,08 Gew% Eisen, 0,06 Gew% Titan, 0,03 Gew% Si und dem Rest Kupfer einschließlich Verunreinigungen ist, oder
    die ausscheidungsgehärtete und/oder dispersionsgehärtete Kupfer-Legierung eine ausscheidungsgehärtete und/oder dispersionsgehärtete Kupfer-Silber-Legierung mit zumindest 90 Gew% Kupfer ist, insbesondere eine ausscheidungsgehärtete und/oder dispersionsgehärtete Kupfer-Silber-Legierung mit mindestens 3 Gew% bis maximal 7 Gew% Silber und dem Rest Kupfer einschließlich Verunreinigungen oder dem Rest Kupfer einschließlich Verunreinigungen und einschließlich 0 Gew% bis maximal 2 Gew% oxidischen Dispersoiden ist, und/oder die Palladium-Legierung eine Palladium-Kupfer-Silber-Legierung mit Palladium als Hauptkomponente ist, wobei die Palladium-Kupfer-Silber-Legierung ein Gewichtsverhältnis von Palladium zu Kupfer von mindestens 1,05 und maximal 1,6 aufweist und ein Gewichtsverhältnis von Palladium zu Silber von mindestens 3 und maximal 6 aufweist und wobei die Palladium-Kupfer-Silber-Legierung mehr als 1 Gew% und bis maximal 6 Gew% Ruthenium, Rhodium oder Ruthenium und Rhodium und als Rest Palladium, Kupfer und Silber und maximal 1 Gew% andere metallische Elemente einschließlich Verunreinigungen enthält, bevorzugt weniger als 0,3 Gew% Iridium enthält, oder

die Palladium-Legierung eine Palladium-Silber-Kupfer-Platin-Legierung ist, insbesondere eine Palladium-Silber-Kupfer-Platin-Zink-Gold-Legierung mit 38 Gew% Silber, 15 Gew% Kupfer, 1,5 Gew% Platin, 1 Gew% Zink, 0,5 Gew% Gold und dem Rest Palladium einschließlich Verunreinigungen ist oder eine Palladium-Silber-Kupfer-Platin-Gold-Zink-Legierung mit 30 Gew% Silber, 14 Gew% Kupfer, 10 Gew% Platin, 10 Gew% Gold, 1 Gew% Zink und dem Rest Palladium einschließlich Verunreinigungen ist, oder

die Palladium-Legierung eine Palladium-Kupfer-Silber-Ruthenium-Legierung, insbesondere eine Palladium-Kupfer-Silber-Ruthenium-Legierung mit 36,5 Gew% Kupfer, 10,5 Gew% Silber, 1,5 Gew% Ruthenium und dem Rest Palladium einschließlich Verunreinigungen ist oder eine Palladium-Kupfer-Silber-Ruthenium-Rhenium-Legierung mit 36,5 Gew% Kupfer, 10,5 Gew% Silber, 1,1 Gew% Ruthenium, 0,4 Gew% Rhenium und dem Rest Palladium einschließlich Verunreinigungen ist, oder

die Palladium-Legierung eine Palladium-Kupfer-Silber-Rhodium-Legierung ist, insbesondere eine Palladium-Kupfer-Silber-Rhodium-Legierung mit 36,5 Gew% Kupfer, 10,5 Gew% Silber, 1,5 Gew% Rhodium und dem Rest Palladium einschließlich Verunreinigungen ist, oder

die Palladium-Legierung eine Palladium-Kupfer-Silber-Legierung ist, insbesondere eine Palladium-Kupfer-Silber-Legierung mit 31 Gew% Kupfer, 29 Gew% Silber und dem Rest Palladium einschließlich Verunreinigungen ist, oder

die Palladium-Legierung eine Palladium-Silber-Kupfer-Legierung ist, insbesondere eine Palladium-Silber-Kupfer-Legierung mit 38 Gew% Silber, 15 Gew% Kupfer und dem Rest Palladium einschließlich Verunreinigungen ist, oder

die Platin-Legierung eine Platin-Nickel-Legierung ist, bevorzugt eine Platin-Nickel-Legierung mit mindestens 3 Gew% und maximal 10 Gew% Nickel und dem Rest Platin einschließlich Verunreinigungen ist, besonders bevorzugt eine Platin-Nickel-Legierung mit 5 Gew% Nickel und dem Rest Platin einschließlich Verunreinigungen ist.

7. Verbundwerkstoff nach einem der vorangehenden Ansprüche, **dadurch gekennzeichnet, dass** die ausscheidungsgehärtete und/oder dispersionsgehärtete Kupfer-Legierung bis zu 2 Gew% Ausscheidungen und/oder Dispersoide aufweist oder aufweisen, bevorzugt bis zu 1 Gew% Ausscheidungen und/oder Dispersoide aufweist oder aufweisen, die Ausscheidungen und/oder Dispersoide zu zumindest 95 Gew% bestehend aus zumindest einem der Elemente ausgewählt aus der Liste, die aus Chrom, Titan, Silizium, Eisen, Sauerstoff, Zirkon und Silber besteht.

8. Verbundwerkstoff nach einem der vorangehenden Ansprüche, **dadurch gekennzeichnet, dass** die innere Kernschicht (1, 11, 21) aus einer ausscheidungsgehärteten und/oder dispersionsgehärteten Palladium-Legierung oder aus einer ausscheidungsgehärteten und/oder dispersionsgehärteten Platin-Legierung besteht.

9. Prüfnadel oder Bondband bestehend aus einem Streifen eines Verbundwerkstoffs nach einem der vorangehenden Ansprüche.

10. Prüfnadel nach Anspruch 9, **dadurch gekennzeichnet, dass** die Prüfnadel eine Spitze aufweist, die aus dem Material der inneren Kernschicht (1, 11, 21) besteht.

11. Prüfnadelarray aufweisend eine Mehrzahl von nebeneinander angeordneten Prüfnadeln nach einem der Ansprüche 9 oder 10.

12. Verwendung eines Verbundwerkstoffs nach einem der Ansprüche 1 bis 8 oder einer Prüfnadel nach Anspruch 9 oder 10 oder eines Prüfnadelarrays nach Anspruch 11 zum Prüfen von elektrischen Kontakten oder zur elektrischen Kontaktierung oder zur Herstellung eines Schleifkontakts.

13. Verfahren zur Herstellung eines Verbundwerkstoffs aus zwei Metall-Legierungen, wobei der Verbundwerkstoff zur Herstellung von Prüfnadeln zur elektronischen Prüfung von Halbleiterelementen geeignet und vorgesehen ist und wobei das Verfahren durch die folgenden, chronologisch aufeinander folgenden Schritte gekennzeichnet ist:

A) Bereitstellen eines ersten Bands aus einer Palladium-Legierung mit zumindest 30 Gew% Palladium oder aus einer Platin-Legierung mit zumindest 30 Gew% Platin und eines zweiten Bands aus einer ausscheidungsgehärteten und/oder dispersionsgehärteten Kupfer-Legierung mit zumindest 90 Gew% Kupfer oder aus einer ausscheidungsgehärteten und/oder dispersionsgehärteten Silber-Legierung mit zumindest 70 Gew% Silber und eines dritten Bands aus einer ausscheidungsgehärteten und/oder dispersionsgehärteten Kupfer-Legierung mit zumindest 90 Gew% Kupfer oder aus einer ausscheidungsgehärteten und/oder dispersionsgehärteten Silber-Legierung mit zumindest 70 Gew% Silber,
B) Anordnen des ersten Bands zwischen das zweite Band und das dritte Band und Aneinanderlegen des ersten Bands an das zweite Band und an das dritte Band, und
C) Verbinden des ersten Bands mit dem zweiten Band und dem dritten Band durch Walzplattieren der aneinander angelegten Bänder, wobei durch das Walzplattieren ein zusammenhängender bandförmiger Verbundwerkstoff aus den Materialien des ersten Bands, des zweiten Bands und der dritten Bands erzeugt wird.

14. Verfahren nach Anspruch 13, **dadurch gekennzeichnet, dass**
nach Schritt C) ein Schritt D) erfolgt:
D) Temperaturbehandlung des in Schritt C) erzeugten Verbunds, wobei bei der Temperaturbehandlung das Material des ersten Bands ausscheidungsgehärtet und/oder dispersionsgehärtet wird.

15. Verfahren nach Anspruch 13 oder 14, **dadurch gekennzeichnet, dass**
mit dem Verfahren ein Verbundwerkstoff nach einem der Ansprüche 1 bis 8 oder mit dem Verfahren durch Schneiden oder Stanzen des Verbundwerkstoffs zumindest eine Prüfnadel oder zumindest ein Bondband nach einem der Ansprüche 9 oder 10 hergestellt wird, bevorzugt mit dem Verfahren durch Schneiden oder Stanzen eine Vielzahl von Prüfnadeln oder Bondbändern nach einem der Ansprüche 9 oder 10 hergestellt werden.

**Claims**

1. A composite material for the production of test needles for the electronic testing of semiconductor elements, wherein the composite material is strip-shaped and is delimited by two mutually parallel main surfaces (4, 5, 14, 15, 24, 25), wherein the composite material is layered perpendicularly to the parallel main surfaces (4, 5, 14, 15, 24, 25) and has a sandwich construction with an inner core layer (1, 11, 21) and two outer cover layers (2, 3, 12, 13, 22, 23), wherein the inner core layer (1, 11, 21) is arranged between the two outer cover layers (2, 3, 12, 13, 22, 23) and the inner core layer (1, 11, 21) is fixedly connected to the two outer cover layers (2, 3, 12, 13, 22, 23) on two opposite sides, wherein the two outer cover layers (2, 3, 12, 13, 22, 23) form the parallel main surfaces (4, 5, 14, 15, 24, 25), wherein the inner core layer (1, 11, 21) consists of a palladium alloy with at least 30 wt.% palladium or of a platinum alloy with at least 30 wt.% platinum and wherein the two outer cover layers (2, 3, 12, 13, 22, 23) consist of a precipitation-hardened and/or dispersion-hardened copper alloy with at least 90 wt.% copper or of a precipitation-hardened and/or dispersion-hardened silver alloy with at least 70 wt.% silver or of a precipitation-hardened and/or dispersion-hardened copper alloy with at least 90 wt.% copper and of a precipitation-hardened and/or dispersion-hardened silver alloy with at least 70 wt.% silver.

2. The composite material according to claim 1, **characterized in that**

the inner core layer (1, 11, 21) is directly connected to the two outer cover layers (2, 3, 12, 13, 22, 23), and/or the composite material consists of the inner core layer (1, 11, 21) and the outer cover layers (2, 3, 12, 13, 22, 23).

3. The composite material according to either of the preceding claims, **characterized in that** the two outer cover layers (2, 3, 12, 13, 22, 23) consist of a precipitation-hardened and/or dispersion-hardened copper alloy with at least 90 wt.% copper, preferably of a precipitation-hardened and/or dispersion-hardened copper alloy with at least 97 wt.% copper, particularly preferably of a precipitation-hardened and/or dispersion-hardened copper alloy with at least 99 wt.% copper.

4. The composite material according to any of the preceding claims, **characterized in that** the inner core layer (1, 11, 21) consists of a palladium alloy containing at least 30 wt.% palladium, preferably of a palladium alloy containing at least 35 wt.% palladium, particularly preferably of a palladium-copper-silver alloy with palladium as the main component, wherein the palladium-copper-silver alloy has a weight ratio of palladium to copper of at least 1.05 and at most 1.6 and a weight ratio of palladium to silver of at least 3 and at most 6 and wherein the palladium-copper-silver alloy contains more than 1 wt.% and up to at most 6 wt.% ruthenium, rhodium or ruthenium and rhodium and contains as the remainder palladium, copper and silver and at most 1 wt.% other metal elements including impurities.

5. The composite material according to any of the preceding claims, **characterized in that** the composite material has an electrical conductivity, measured by a four-point measuring method at room temperature on one of the two outer cover layers (2, 3, 12, 13, 22, 23), of at least 35% IACS (20.3 $10^6$ S/m), preferably at least 40% IACS (23.2 $10^6$ S/m), particularly preferably at least 45% IACS (26.1 $10^6$ S/m), wherein the electrical conductivity is determined by a 4-pole measurement of the voltage drop on the test specimen at a defined length using a Burster Resistomat 2316 and the measurement is carried out on the main surfaces of the composite material with an area having an edge length of 5 mm or more, a thickness of 55 $\mu$m and a measuring current of 10 mA, and/or the composite material has a Vickers hardness HV0.05 (HV0.05 - Vickers hardness test according to DIN EN ISO 6507-1:2018 to -4:2018 with a test force of 0.4905 N (0.05 kilopond)) at room temperature in the two cover layers (2, 3, 12, 13, 22, 23) of at least 170, preferably of at least 190, particularly preferably of at least 196, and/or the composite material has a tensile strength at room temperature parallel to the plane of the inner core layer (1, 11, 21) of at least 1000 MPa, which is determined by tensile tests using a Zwick tensile testing machine Z250 on a composite material with a thickness of 50 $\mu$m and a width of 13 mm and wherein the testing speed is 1 mm/min, preferably of at least 1100 MPa, and/or the composite material has a yield strength at room temperature parallel to the plane of the inner core layer (1, 11, 21) of at least 950 MPa, preferably of at least 1050 MPa, wherein the 0.2% proof stress Rp0.2 is determined using a Zwick Z250 tensile testing machine, on a composite material with a thickness of 50 $\mu$m and a width of 13 mm, and wherein the testing speed with respect to the yield strength Rp0.2 is 1 mm/min.

6. The composite material according to any of the preceding claims, **characterized in that** the precipitation-hardened and/or dispersion-hardened copper alloy is a precipitation-hardened and/or dispersion-hardened copper-chromium alloy with at least 98 wt.% copper, in particular a precipitation-hardened and/or dispersion-hardened CuCr1Zr alloy with at least 0.5 wt.% and at most 1.2 wt.% chromium and with at least 0.03 wt.% to at most 0.3 wt.% zirconium and the remainder copper including impurities, or

the precipitation-hardened and/or dispersion-hardened copper alloy is a precipitation-hardened copper-chromium-titanium alloy with at least 99 wt.% copper, in particular a precipitation-hardened copper-chromium-titanium-silicon alloy with 0.3 wt.% chromium, 0.1 wt.% titanium, 0.02 wt.% Si and the remainder copper including impurities, or the precipitation-hardened and/or dispersion-hardened copper alloy is a precipitation-hardened copper-chromium-silver alloy with at least 98 wt.% copper, in particular a precipitation-hardened copper-chromium-silver-iron-titanium-silicon alloy with 0.5 wt.% chromium, 0.2 wt.% silver, 0.08 wt.% iron, 0.06 wt.% titanium, 0.03 wt.% Si and the remainder copper including impurities, or

the precipitation-hardened and/or dispersion-hardened copper alloy is a precipitation-hardened and/or dispersion-hardened copper-silver alloy with at least 90 wt.% copper, in particular a precipitation-hardened and/or dispersion-hardened copper-silver alloy with at least 3 wt.% to at most 7 wt.% silver and the remainder copper including impurities or the remainder copper including impurities and including 0 wt.% to at most 2 wt.% oxidic dispersoids, and/or

the palladium alloy is a palladium-copper-silver alloy with palladium as the main component, wherein the palladium-copper-silver alloy has a weight ratio of palladium to copper of at least 1.05 and at most 1.6 and a weight ratio of palladium to silver of at least 3 and at most 6, and wherein the palladium-copper-silver alloy contains more than 1 wt.% and up to at most 6 wt.% ruthenium, rhodium or ruthenium and rhodium and, as the remainder, palladium, copper and silver and at most 1 wt.% other metal elements including impurities, preferably less than 0.3 wt.% iridium, or

the palladium alloy is a palladium-silver-copper-platinum alloy, in particular a palladium-silver-copper-platinum-zinc-gold alloy with 38 wt.% silver, 15 wt.% copper, 1.5 wt.% platinum, 1 wt.% zinc, 0.5 wt.% gold and the remainder palladium including impurities, or a palladium-silver-copper-platinum-gold-zinc alloy with 30 wt.% silver, 14 wt.% copper, 10 wt.% platinum, 10 wt.% gold, 1 wt.% zinc and the remainder palladium including impurities, or

the palladium alloy is a palladium-copper-silver-ruthenium alloy, in particular a palladium-copper-silver-ruthenium alloy with 36.5 wt.% copper, 10.5 wt.% silver, 1.5 wt.% ruthenium and the remainder palladium including impurities, or a palladium-copper-silver-ruthenium-rhenium alloy with 36.5 wt.% copper, 10.5 wt.% silver, 1.1 wt.% ruthenium, 0.4 wt.% rhenium and the remainder palladium including impurities, or

the palladium alloy is a palladium-copper-silver-rhodium alloy, in particular a palladium-copper-silver-rhodium alloy with 36.5 wt.% copper, 10.5 wt.% silver, 1.5 wt.% rhodium and the remainder palladium including impurities, or

the palladium alloy is a palladium-copper-silver alloy, in particular a palladium-copper-silver alloy with 31 wt.% copper, 29 wt.% silver and the remainder palladium including impurities, or the palladium alloy is a palladium-silver-copper alloy, in particular a palladium-silver-copper alloy with 38 wt.% silver, 15 wt.% copper and the remainder palladium including impurities, or the platinum alloy is a platinum-nickel alloy, preferably a platinum-nickel alloy with at least 3 wt.% and at most 10 wt.% nickel and the remainder platinum including impurities, particularly preferably a platinum-nickel alloy with 5 wt.% nickel and the remainder platinum including impurities.

7. The composite material according to any of the preceding claims, **characterized in that** the precipitation-hardened and/or dispersion-hardened copper alloy comprises or comprise up to 2 wt.% precipitates and/or dispersoids, preferably comprises or comprise up to 1 wt.% precipitates and/or dispersoids, at least 95 wt.% of the precipitates and/or dispersoids consisting of at least one of the elements selected from the list consisting of chromium, titanium, silicon, iron, oxygen, zirconium and silver.

8. The composite material according to any of the preceding claims, **characterized in that** the inner core layer (1, 11, 21) consists of a precipitation-hardened and/or dispersion-hardened palladium alloy or of a precipitation-hardened and/or dispersion-hardened platinum alloy.

9. A test needle or bonding strip consisting of a band of a composite material according to any of the preceding claims.

10. The test needle according to claim 9, **characterized in that**
the test needle comprises a tip consisting of the material of the inner core layer (1, 11, 21).

11. A test needle array comprising a plurality of test needles according to one of claims 9 or 10 arranged side by side.

12. A use of a composite material according to any of claims 1 to 8 or a test needle according to claim 9 or 10 or a test needle array according to claim 11 for testing electrical contacts or for electrical contacting or for the production of a sliding contact.

13. A method for producing a composite material from two metal alloys, wherein the composite material is suitable and intended for the production of test needles for the electronic testing of semiconductor elements and wherein the method is **characterized by** the following chronologically successive steps:

   A) providing a first strip made of a palladium alloy with at least 30 wt.% palladium or of a platinum alloy with at least 30 wt.% platinum and a second strip made of a precipitation-hardened and/or dispersion-hardened copper alloy with at least 90 wt.% copper or of a precipitation-hardened and/or dispersion-hardened silver alloy with at least 70 wt.% silver and a third strip made of a precipitation-hardened and/or dispersion-hardened copper alloy with at least 90 wt.% copper or of a precipitation-hardened and/or dispersion-hardened silver alloy with at least 70 wt.% silver,
   B) arranging the first strip between the second strip and the third strip and placing the first strip against the second strip and the third strip, and
   C) connecting the first strip to the second strip and the third strip by roll bonding the strips placed against one another, wherein the roll bonding produces a contiguous strip-shaped composite material from the materials of the first strip, the second strip and the third strip.

14. The method according to claim 13, **characterized in that**
after step C) a step D) takes place:
D) temperature treatment of the composite produced in step C), with the material of the first strip being precipitation-hardened and/or dispersion-hardened during the temperature treatment.

15. The method according to claim 13 or 14, **characterized in that**
a composite material according to any of claims 1 to 8 is produced using the method or at least one test needle or at least one bonding strip according to one of claims 9 or 10 is produced using the method by cutting or punching of the composite material, preferably a plurality of test needles or bonding strips according to one of claims 9 or 10 are produced using the method by cutting or punching.

**Revendications**

1. Matériau composite pour la fabrication d'aiguilles d'essai pour l'essai électronique d'éléments semi-conducteurs, dans lequel le matériau composite est en forme de bande et est délimité par deux surfaces principales (4, 5, 14, 15, 24, 25) parallèles entre elles, dans lequel le matériau composite est stratifié perpendiculairement aux surfaces principales (4, 5, 14, 15, 24, 25) parallèles et présente une construction en sandwich comportant une couche centrale intérieure (1, 11, 21) et deux couches de recouvrement extérieures (2, 3, 12, 13, 22, 23), dans lequel la couche centrale intérieure (1, 11, 21) est disposée entre les deux couches de recouvrement extérieures (2, 3, 12, 13, 22, 23) et la couche centrale intérieure (1, 11, 21) est reliée sur deux côtés opposés aux deux couches de recouvrement extérieures (2, 3, 12, 13, 22, 23) de manière fixe, dans lequel les deux couches de recouvrement extérieures (2, 3, 12, 13, 22, 23) forment les surfaces principales (4, 5, 14, 15, 24, 25) parallèles, dans lequel la couche centrale intérieure (1, 11, 21) est constituée d'un alliage de palladium comportant au moins 30 % en poids de palladium ou d'un alliage de platine comportant au moins 30 % en poids de platine et dans lequel les deux couches de recouvrement extérieures (2, 3, 12, 13, 22, 23) sont constituées d'un alliage de cuivre durci par précipitation et/ou durci par dispersion et comportant au moins 90 % en poids de cuivre ou d'un alliage d'argent durci par précipitation et/ou durci par dispersion et comportant au moins 70 % en poids d'argent ou d'un alliage de cuivre durci par précipitation et/ou durci par dispersion et comportant au moins 90 % en poids de cuivre et d'un alliage d'argent durci par précipitation et/ou durci par dispersion et comportant au moins 70 % en poids d'argent.

2. Matériau composite selon la revendication 1, **caractérisé en ce que**

   la couche centrale intérieure (1, 11, 21) est directement reliée aux deux couches de recouvrement extérieures (2, 3, 12, 13, 22, 23), et/ou
   le matériau composite est constitué de la couche centrale intérieure (1, 11, 21) et des couches de recouvrement extérieures (2, 3, 12, 13, 22, 23).

3. Matériau composite selon l'une des revendications précédentes, **caractérisé en ce que**
   les deux couches de recouvrement extérieures (2, 3, 12, 13, 22, 23) sont constituées d'un alliage de cuivre durci par précipitation et/ou durci par dispersion et comportant au moins 90 % en poids de cuivre, de préférence d'un alliage de cuivre durci par précipitation et/ou durci par dispersion et comportant au moins 97 % en poids de cuivre, de manière particulièrement préférée d'un alliage de cuivre durci par précipitation et/ou durci par dispersion et comportant au moins 99 % en poids de cuivre.

4. Matériau composite selon l'une des revendications précédentes, **caractérisé en ce que**
   la couche centrale intérieure (1, 11, 21) est constituée d'un alliage de palladium contenant au moins 30 % en poids de palladium, de préférence d'un alliage de palladium contenant au moins 35 % en poids de palladium, de manière particulièrement préférée d'un alliage de palladium-cuivre-argent comportant du palladium comme composant principal, dans lequel l'alliage de palladium-cuivre-argent présente un rapport pondéral du palladium au cuivre d'au moins 1,05 et d'au maximum 1,6 et un rapport pondéral du palladium à l'argent d'au moins 3 et d'au maximum 6 et dans lequel l'alliage de palladium-cuivre-argent contient plus de 1 % en poids et jusqu'au maximum 6 % en poids de ruthénium, de rhodium ou de ruthénium et de rhodium, et le reste étant constitué de palladium, de cuivre et d'argent et d'au maximum 1 % en poids d'autres éléments métalliques, y compris des impuretés.

5. Matériau composite selon l'une des revendications précédentes, **caractérisé en ce que**

   le matériau composite présente une conductivité électrique mesurée par un procédé de mesure en quatre points à température ambiante sur l'une des deux couches de recouvrement extérieures (2, 3, 12, 13, 22, 23) d'au moins 35 % IACS (20,3 $10^6$ S/m), de préférence d'au moins 40 % IACS (23,2 $10^6$ S/m), de manière particulièrement préférée d'au moins 45 % IACS (26,1 $10^6$ S/m), dans lequel la conductivité électrique est déterminée par une mesure quadripolaire de la chute de tension au niveau de l'objet à essayer à une longueur définie avec un appareil de type Burster Resistomat 2316 et la mesure est effectuée sur les surfaces principales du matériau composite avec une surface comportant une longueur de bord de 5 mm ou plus, une épaisseur de 55 $\mu$m et un courant de mesure de 10 mA, et/ou
   le matériau composite présente une dureté Vickers HV0,05 (HV0,05 - essai de dureté Vickers selon les normes DIN EN ISO 6507-1:2018 à DIN EN ISO 6507-4:2018 avec une force d'essai de 0,4905 N (0,05 kilogramme-force)) à température ambiante dans les deux couches de recouvrement (2, 3, 12, 13, 22, 23) d'au moins 170, de préférence d'au moins 190, de manière particulièrement préférée d'au moins 196, et/ou
   le matériau composite présente une résistance à la traction à température ambiante parallèlement au plan de la couche centrale intérieure (1, 11, 21) d'au moins 1000 MPa, déterminée par des essais de traction avec une machine d'essai de traction Zwick Z250 sur un matériau composite d'une épaisseur de 50 μm et d'une largeur de 13 mm et dans lequel la vitesse d'essai est de 1 mm/min, de préférence d'au moins 1100 MPa, et/ou le matériau composite présente une limite d'élasticité à température ambiante parallèlement au plan de la couche centrale intérieure (1, 11, 21) d'au moins 950 MPa, de préférence d'au moins 1050 Mpa, dans lequel la limite d'allongement à 0,2 % Rp0,2 est déterminée avec une machine d'essai de traction Zwick Z250, est effectuée sur un matériau composite d'une épaisseur de 50 μm et d'une largeur de 13 mm, et dans lequel la vitesse d'essai par rapport à la limite d'élasticité Rp0,2 est de 1 mm/min.

6.  Matériau composite selon l'une des revendications précédentes, **caractérisé en ce que**

l'alliage de cuivre durci par précipitation et/ou durci par dispersion est un alliage de cuivre-chrome durci par précipitation et/ou durci par dispersion et comportant au moins 98 % en poids de cuivre, en particulier un alliage de CuCr1Zr durci par précipitation et/ou durci par dispersion et comportant au moins 0,5 % en poids et au maximum 1,2 % en poids de chrome et comportant au moins 0,03 % en poids et au maximum 0,3 % en poids de zirconium, et le reste étant constitué de cuivre, y compris des impuretés, ou

l'alliage de cuivre durci par précipitation et/ou durci par dispersion est un alliage de cuivre-chrome-titane durci par précipitation et comportant au moins 99 % en poids de cuivre, en particulier un alliage de cuivre-chrome-titane-silicium durci par précipitation et comportant 0,3 % en poids de chrome, 0,1 % en poids de titane, 0,02 % en poids de Si et le reste étant constitué de cuivre, y compris des impuretés, ou

l'alliage de cuivre durci par précipitation et/ou durci par dispersion est un alliage de cuivre-chrome-argent durci par précipitation et comportant au moins 98 % en poids de cuivre, en particulier un alliage de cuivre-chrome-argent-fer-titane-silicium durci par précipitation et comportant 0,5 % en poids de chrome, 0,2 % en poids d'argent, 0,08 % en poids de fer, 0,06 % en poids de titane, 0,03 % en poids de Si et le reste étant constitué de cuivre, y compris des impuretés, ou

l'alliage de cuivre durci par précipitation et/ou durci par dispersion est un alliage de cuivre-argent durci par précipitation et/ou durci par dispersion et comportant au moins 90 % en poids de cuivre, en particulier un alliage de cuivre-argent durci par précipitation et/ou durci par dispersion et comportant au moins 3 % en poids jusqu'au maximum 7 % en poids d'argent, et le reste étant constitué de cuivre, y compris des impuretés, ou le reste étant constitué de cuivre, y compris des impuretés, et y compris 0 % en poids jusqu'au maximum 2 % en poids de dispersoïdes d'oxyde, et/ou

l'alliage de palladium est un alliage de palladium-cuivre-argent comportant du palladium comme composant principal, dans lequel l'alliage de palladium-cuivre-argent présente un rapport pondéral du palladium au cuivre d'au moins 1,05 et d'au maximum 1,6 et un rapport pondéral du palladium à l'argent d'au moins 3 et d'au maximum 6 et dans lequel l'alliage de palladium-cuivre-argent contient plus de 1 % en poids et jusqu'au maximum 6 % en poids de ruthénium, de rhodium ou de ruthénium et de rhodium, et le reste étant constitué de palladium, de cuivre et d'argent et d'au maximum 1 % en poids d'autres éléments métalliques, y compris des impuretés, de préférence moins de 0,3 % en poids d'iridium, ou

l'alliage de palladium est un alliage de palladium-argent-cuivre-platine, en particulier un alliage de palladium-argent-cuivre-platine-zinc-or comportant 38 % en poids d'argent, 15 % en poids de cuivre, 1,5 % en poids de platine, 1 % en poids de zinc, 0,5 % en poids d'or, et le reste étant constitué de palladium, y compris des impuretés, ou un alliage de palladium-argent-cuivre-platine-or-zinc comportant 30 % en poids d'argent, 14 % en poids de cuivre, 10 % en poids de platine, 10 % en poids d'or, 1 % en poids de zinc, et le reste étant constitué de palladium, y compris des impuretés, ou

l'alliage de palladium est un alliage de palladium-cuivre-argent-ruthénium, en particulier un alliage de palladium-cuivre-argent-ruthénium comportant 36,5 % en poids de cuivre, 10,5 % en poids d'argent, 1,5 % en poids de ruthénium, et le reste étant constitué de palladium, y compris des impuretés, ou un alliage de palladium-cuivre-argent-ruthénium-rhénium comportant 36,5 % en poids de cuivre, 10,5 % en poids d'argent, 1,1 % en poids de ruthénium, 0,4 % en poids de rhénium, et le reste étant constitué de palladium, y compris des impuretés, ou

l'alliage de palladium est un alliage de palladium-cuivre-argent-rhodium, en particulier un alliage de palladium-cuivre-argent-rhodium comportant 36,5 % en poids de cuivre, 10,5 % en poids d'argent, 1,5 % en poids de rhodium, et le reste étant constitué de palladium, y compris des impuretés, ou

l'alliage de palladium est un alliage de palladium-cuivre-argent, en particulier un alliage de palladium-cuivre-argent comportant 31 % en poids de cuivre, 29 % en poids d'argent, et le reste étant constitué de palladium, y compris des impuretés, ou

l'alliage de palladium est un alliage de palladium-argent-cuivre, en particulier un alliage de palladium-argent-cuivre comportant 38 % en poids d'argent, 15 % en poids de cuivre, et le reste étant constitué de palladium, y compris des impuretés, ou

l'alliage de platine est un alliage de platine-nickel, de préférence un alliage de platine-nickel comportant au moins 3 % en poids et au maximum 10 % en poids de nickel, et le reste étant constitué de platine, y compris des impuretés, de manière particulièrement préférée un alliage de platine-nickel comportant 5 % en poids de nickel, et le reste étant constitué de platine, y compris des impuretés.

7.  Matériau composite selon l'une des revendications précédentes, **caractérisé en ce que**
    l'alliage de cuivre durci par précipitation et/ou durci par dispersion présente jusqu'à 2 % en poids de précipités et/ou de dispersoïdes, de préférence jusqu'à 1 % en poids de précipités et/ou de dispersoïdes, les précipités et/ou les dispersoïdes étant constitués à au moins 95 % en poids d'au moins l'un des éléments choisis dans la liste constituée de chrome, titane, silicium, fer, oxygène, zircon et argent.

8.  Matériau composite selon l'une des revendications précédentes, **caractérisé en ce que**
    la couche centrale intérieure (1, 11, 21) est constituée d'un alliage de palladium durci par précipitation et/ou durci par dispersion ou d'un alliage de platine durci par précipitation et/ou durci par dispersion.

9.  Aiguille d'essai ou bande de liaison constituée d'un ruban de matériau composite selon l'une des revendications précédentes.

10. Aiguille d'essai selon la revendication 9, **caractérisée en ce que**
    l'aiguille d'essai présente une pointe qui est constituée du matériau de la couche centrale intérieure (1, 11, 21).

11. Réseau d'aiguilles d'essai présentant une pluralité d'aiguilles d'essai disposées côte à côte selon l'une des revendications 9 ou 10.

12. Utilisation d'un matériau composite selon l'une des revendications 1 à 8 ou d'une aiguille d'essai selon la revendication 9 ou 10 ou d'un réseau d'aiguilles d'essai selon la revendication 11 pour l'essai de contacts électriques ou pour l'établissement d'un contact électrique ou pour l'établissement d'un contact à frottement.

13. Procédé pour la fabrication d'un matériau composite à partir de deux alliages métalliques, dans lequel le matériau composite est approprié et prévu pour la fabrication d'aiguilles d'essai pour l'essai électronique d'éléments semi-conducteurs et dans lequel le procédé est **caractérisé par** les étapes suivantes se suivant chronologiquement :

    A) fourniture d'une première bande en un alliage de palladium comportant au moins 30 % en poids de palladium ou en un alliage de platine comportant au moins 30 % en poids de platine et d'une deuxième bande en un alliage de cuivre durci par précipitation et/ou durci par dispersion et comportant au moins 90 % en poids de cuivre ou d'un alliage d'argent durci par précipitation et/ou durci par dispersion et comportant au moins 70 % en poids d'argent et d'une troisième bande en un alliage de cuivre durci par précipitation et/ou durci par dispersion et comportant au moins 90 % en poids de cuivre ou d'un alliage d'argent durci par précipitation et/ou durci par dispersion et comportant au moins 70 % en poids d'argent,
    B) disposition de la première bande entre la deuxième bande et la troisième bande et juxtaposition de la première bande à la deuxième bande et à la troisième bande, et
    C) liaison de la première bande à la deuxième bande et à la troisième bande par placage par laminage des bandes juxtaposées les unes sur les autres, dans lequel un matériau composite cohérent en forme de bande est produit par le placage par laminage à partir des matériaux de la première bande, de la deuxième bande et de la troisième bande.

14. Procédé selon la revendication 13, **caractérisé en ce que**
    l'étape C) est suivie d'une étape D) :
    D) traitement thermique du composite produit à l'étape C), dans lequel, lors du traitement thermique, le matériau de la première bande est durci par précipitation et/ou durci par dispersion.

15. Procédé selon la revendication 13 ou 14, **caractérisé en ce que**
    avec le procédé, un matériau composite selon l'une des revendications 1 à 8 est fabriqué ou, avec le procédé, au moins une aiguille d'essai ou au moins une bande de liaison selon l'une des revendications 9 ou 10 est fabriquée par découpe ou estampage du matériau composite, de préférence, avec le procédé, une pluralité d'aiguilles d'essai ou de bandes de liaison selon l'une des revendications 9 ou 10 est fabriquée par découpe ou estampage.

**Figur 1**

**Figur 2**

Figur 3

Figur 4

101: Bereitstellen eines Bands einer Pd-Legierung mit zumindest 30 Gew%
Palladium und zweier Bänder einer Cu-Legierung mit zumindest 90 Gew% Kupfer

↓

102: Aufeinanderlegen der Bänder (Pd-Legierung zwischen Cu-Legierung)

↓

103: Walzplattieren der aufeinander gelegten Bänder

↓

104: Optional: Reduzieren der Stärke des walzplattierten Verbunds durch Walzen

↓

105: Ordnungsglühen des Verbunds zwischen 350 °C und 400 °C

↓

106: Optional: Herstellen von Streifen durch Schneiden oder Stanzen

↓

107: Optional: Endfertigen von Prüfnadeln oder Bondbändern

**Figur 5**

**IN DER BESCHREIBUNG AUFGEFÜHRTE DOKUMENTE**

**In der Beschreibung aufgeführte Patentdokumente**

- US 20140266278 A1
- US 20100194415 A1
- US 2014377129 A1
- US 5833774 A
- US 20100239453 A1
- EP 2248920 A1
- US 20060197542 A1
- US 1913423 A
- GB 354216 A
- EP 3960890 A1
- US 10385424 B2
- WO 2016009293 A1
- US 20130099813 A1
- US 20160252547 A1
- EP 2060921 A1
- US 20120286816 A1
- US 20190101569 A1
- DE 102019130522 A1
- DE 69635227 T2
- EP 2139012 A1
- US 20190064215 A1
- EP 3862759 B1
- WO 2016107729 A1
- US 20170307657 A1
- US 20140176172 A1